# EUROPEAN PATENT APPLICATION

(11) **EP 4 607 941 A1**
(43) Date of publication of application: **27.08.2025**
(21) Application number: 23880197.1
(22) Date of filing: 17.10.2023
(51) Int. Cl.: H04N 23/68, H04N 23/54, H04N 23/55, H04N 23/57, G03B 5/00, H02K 33/18, H05K 1/18

(54) **CAMERA MODULE AND OPTICAL DEVICE INCLUDING SAME**

(30) Priority: 17.10.2022 KR 20220133130
(71) Applicant: LG INNOTEK CO. LTD, Gangseo-gu Seoul 07796 (KR)
(72) Inventor: HAN, Sang Yeon, Seoul 07796 (KR)
(74) Representative: DREISS Patentanwälte PartG mbB
(86) International application number: PCT/KR2023/016085
(87) International publication number: WO 2024/085620

(57) **Abstract**

A camera module according to an embodiment includes a first substrate having a first terminal part; an image sensor disposed on the first substrate; a base disposed on the first substrate; a lens driving device including a second substrate disposed on the base and having a second terminal part; and a connection pin penetrating the base, and wherein one end of the connection pin contacts the first terminal part, and the other end of the connection pin contacts the second terminal part.

## Description

### [Technical Field]

An embodiment relates to a camera module and an optical device including same.

### [Background Art]

A camera module performs a function of photographing a subject and storing it as an image or a moving image, and is mounted in various devices such as mobile terminals such as cell phones, laptops, drones, and vehicles.

Typically, the above-described device is equipped with an ultra-small camera module. The camera module may perform an autofocus (AF function adjusting automatically a distance between an image sensor and a lens to adjust a focal length of the lens.

In addition, recently, a camera module adopts an image stabilization (IS technology to correct or prevent image shake caused by camera movement due to an unstable fixing device or user movement.

Such an image stabilization (IS technology includes an optical image stabilizer (OIS technology and an image stabilization technology using an image sensor. Here, the OIS technology is a technology that corrects movement by changing a light path, and the image stabilization technology using the image sensor is a technology that corrects movement by mechanical and electronic methods, but the OIS technology is often used.

Accordingly, the camera module includes an actuator for performing an auto focus function and an image stabilization function. The actuator may also be referred to as a lens driving part, and provides a driving force for moving or tilting the lens driving part along a first axis, a second axis, and a third axis.

The lens driving part includes a driving coil for providing a driving force based on each axis, and a position sensor for detecting a position of the lens module.

Accordingly, in a conventional camera module, soldering points between the actuator and the driver or module connector increase, and accordingly problems occur in a soldering process. Here, the soldering point may mean a connection contact point through which the actuator and the module connector or driver are electrically connected. For example, the soldering point includes a connection contact point between a plurality of driving coils and the module connector or driver. For example, the soldering point includes a connection contact point between a plurality of position sensors and the module connector or driver.

At this time, conventionally, each driving coil and each position sensor were connected to the module connector or driver. Accordingly, conventionally, there is a problem that the soldering points between the actuator and the module connector or driver increase, and a manufacturing process becomes complicated accordingly. Furthermore, in conventional camera modules, a volume of a circuit board increases as the soldering points increase, and there is a problem that design restrictions occur due to spatial problems.

In addition, according to the conventional technology, electrical reliability problems occur due to defects in a soldering process. In addition, according to the conventional technology, cracks occur at the soldering points in terms of impact reliability and environmental reliability.

(Patent Document 1) KR 10-2017-0053274 A

### [Disclosure]

### [Technical Problem]

An embodiment provides a camera module having a novel structure and an optical device including the same.

In addition, the embodiment provides a camera module capable of improving bonding reliability between a lens driving device and a first substrate and an optical device including the same.

In addition, the embodiment provides a camera module capable of omitting a soldering process and an optical device including the same.

In addition, the embodiment provides a camera module having improved electrical reliability and an optical device including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A camera module according to an embodiment a first substrate having a first terminal part; an image sensor disposed on the first substrate; a base disposed on the first substrate; a lens driving device including a second substrate disposed on the base and having a second terminal part; and a connection pin penetrating the base, and wherein one end of the connection pin contacts the first terminal part, and other end of the connection pin contacts the second terminal part.

In addition, the connection pin includes: a body penetrating the base, a first connection part having the one end protruding in a lower direction of the body and contacting the first terminal part; and a second connection part having the other end protruding in an upper direction of the body and contacting the second terminal part.

In addition, at least one of the first connection part and the second connection part has elasticity.

In addition, the base includes an insertion hole into which the body of the connection pin is inserted, and the insertion hole penetrates the base at a position spaced from an outer end of the base.

In addition, the base includes a first region including the insertion hole, and a second region adjacent to the first region, and the first region and the second region do not have a step.

In addition, the base includes a first region including the insertion hole, and a second region adjacent to the first region, and the first region and the second region have a step.

In addition, the first region of the base is provided with a recess corresponding to the step, and the recess includes a first recess provided on one surface of the base, in which a first adhesive member for coupling the first connection part and the first terminal part is disposed, and a second recess provided on other surface of the base opposite to the one surface, in which a second adhesive member for coupling the second connection part and the second terminal part is disposed.

In addition, the lens driving device includes a driving coil disposed on the second substrate, the second terminal part includes a plurality of second terminals, and at least one of the plurality of second terminals is electrically connected to the driving coil.

In addition, the lens driving device further includes a mover that moves with respect to the second substrate and includes a sensor unit, and at least another one of the plurality of second terminals includes a terminal electrically connected to the sensor unit.

In addition, the first terminal part and the second terminal part overlap in an optical axis direction, the insertion hole is aligned with the first terminal part and the second terminal part in the optical axis direction, and a peripheral region adjacent to the first terminal part among an upper surface of the first substrate overlaps with the base in the optical axis direction.

In addition, the lens driving device further includes a holder on which the second substrate is disposed, the second substrate includes a first substrate region that is disposed on the holder and on which the driving coil is disposed, and a second substrate region that is bent from the first substrate region, and the second terminal part is disposed on the second substrate region of the second substrate.

In addition, the second substrate region of the second substrate includes a first sub-region bent from one end of the first substrate region of the second substrate and disposed on a side portion of the holder, and a second sub-region bent from the first sub-region and disposed on a lower portion of the holder, and the second terminal part is disposed on a lower surface of the second sub-region facing the upper surface of the base.

In addition, the second terminal part includes a first portion disposed on a lower surface of the second sub-region and in contact with the first connection part of the connection pin, and a second portion extending from the first portion and disposed on a side surface of the first sub-region.

In addition, the lens driving device further includes a holder on which the second substrate is disposed, the second substrate includes a substrate region disposed on the holder and on which the driving coil is disposed, the second terminal part is disposed on a lower surface of the substrate region, the holder includes a through hole vertically overlapping the second terminal part and through which the second connection part of the connection pin passes.

In addition, the second terminal part includes a first portion disposed on a lower surface of the substrate region and in contact with the first connection part of the connection pin, and a second portion extending from the first portion and disposed on a side surface of the substrate region.

In addition, the first terminal part includes a first-first terminal part disposed on one side of the image sensor among the upper surface of the first substrate, and a first-second terminal part disposed on other side opposite the one side of the image sensor among the upper surface of the first substrate, and the second terminal part includes a second-first terminal part corresponding to the first-first terminal part, and a second-second terminal part corresponding to the first-second terminal part, and the connection pin includes a first connection pin contacting the first-first terminal part and the second-first terminal part, respectively, and a second connection pin contacting the first-second terminal part and the second-second terminal part, respectively.

In addition, at least one of the first connection part and the second connection part includes a flat surface, and at least one of the first terminal part and the second terminal part includes a flat surface corresponding to the first connection part or the second connection part.

In addition, at least one of the first connection part and the second connection part includes an inwardly concave surface, and at least one of the first terminal part and the second terminal part includes an outwardly convex surface corresponding to the concave surface of the first connection part or the second connection part.

In addition, at least one of the first connection part and the second connection part includes an outwardly convex surface, and at least one of the first terminal part and the second terminal part includes an inwardly concave surface corresponding to the convex surface of the first connection part or the second connection part.

Meanwhile, the camera module of the embodiment includes a first substrate including a first terminal part; an image sensor disposed on the first substrate; a base disposed on the first substrate; a lens driving device including a second substrate disposed on the base, wherein the second substrate including a second terminal part; and a connection pin in contact with the first terminal part and the second terminal part, and the base includes a hole into which the connection pin is inserted, and at least one end of the connection pin has elasticity.

Meanwhile, the camera module of the embodiment includes a substrate; an image sensor disposed on the substrate; a lens driving device disposed on the substrate; and a base disposed between the substrate and the lens driving device, the base including an upper surface having a first groove, a lower surface having a second groove, and a through hole penetrating the first groove and the second groove, and a side wall of the base in a region where the through hole is disposed is exposed to an outside.

Meanwhile, the camera module of the embodiment includes a first substrate including a plurality of first terminals; an image sensor disposed on the first substrate; a base disposed on the first substrate; a lens driving device including a second substrate disposed on the base and including a plurality of second terminals; and a connection part in contact with the plurality of first terminals and the plurality of second terminals, the base includes an opening part corresponding to the image sensor and a first region through which the connection part passes, and the first region of the base is positioned between the opening part and one side surface of the base.

### [Effects of the Invention]

The camera module of the embodiment can improve electrical connection reliability between a driving substrate part and a lens driving device.

Specifically, the driving substrate part includes a first substrate including a first terminal part. In addition, the lens driving device includes a second substrate including a second terminal part. At this time, a base of a filter part is disposed between the first substrate and the second substrate. The base includes an insertion hole. In addition, the camera module of the embodiment includes a connection pin inserted into the insertion hole. At this time, the connection pin includes a first connection part connected to the first terminal part of the first substrate and a second connection part connected to the second terminal part of the second substrate while being inserted into the insertion hole of the base. The connection part electrically connects the first substrate and the second substrate while being supported by the base.

Accordingly, the embodiment can omit a soldering process for electrically connecting the first terminal part and the second terminal part. By this, the embodiment can solve electrical reliability and physical reliability problems occurring in the soldering process. In addition, the embodiment can solve a problem of cracks occurring at a point where the soldering process is performed due to various factors.

In addition, the embodiment can secure a flatness of the base where an infrared filter is disposed. Accordingly, the embodiment can secure the flatness of the infrared filter. Specifically, a base of a comparative example includes an opening part in which a region where the second terminal part of the second substrate is formed is opened. At this time, due to the technological development of the camera module, a size of the image sensor is increasing, and accordingly, a size of the infrared filter is also increasing. In addition, the base of the comparative example must secure a region where the opening part is formed, and thus, there is a problem that a rigidity of the base is reduced. In addition, the comparative example has a problem that the size of the base is increased by a region where the opening part is formed, and thus, an overall size of the camera module is increased. In contrast, the embodiment does not have to form the opening part in the base. Accordingly, the embodiment can improve the rigidity of the base. Therefore, the camera module of the embodiment can improve the flatness of the base and further improve the flatness of the infrared filter.

Furthermore, the camera module of the comparative example performs a soldering process for electrically connecting the first substrate and the second substrate from an outside. Therefore, the camera module of the comparative example has a solder portion that electrically connects the first substrate and the second substrate exposed to the outside of the camera module. Therefore, in the comparative example, electrical reliability and physical reliability problems are caused by the solder portion being exposed to the outside.

In contrast, the camera module of the embodiment electrically connects the first substrate and the second substrate using a connection pin. Therefore, the camera module of the embodiment can have a contact point between the first terminal part of the first substrate and the second terminal part of the second substrate located at an inside of the camera module. Therefore, the embodiment can protect the contact point from various factors. Accordingly, the embodiment can further improve the electrical connectivity between the first substrate and the second substrate. Furthermore, the embodiment can improve the operational reliability of the camera module.

### [Description of Drawings]

FIG. 1 is a perspective view of a camera module according to an embodiment.
FIG. 2 is a cross-sectional view of the camera module of FIG. 1 taken along line A-A'.
FIG. 3 is a cross-sectional view of the camera module of FIG. 1 taken along line B-B'.
FIG. 4 is an exploded perspective view of the camera module of FIG. 1.
FIG. 5 is a side view of the lens driving device of FIG. 4.
FIG. 6 is an exploded perspective view of the lens driving device of FIG. 4.
FIG. 7a is a perspective view of a second substrate according to a first embodiment viewed from an upper direction.
FIG. 7b is a perspective view of a second substrate according to a first embodiment viewed from a lower direction.
FIG. 8a is a perspective view of a second substrate according to a second embodiment viewed from a lower direction.
FIG. 8b is a perspective view of a second substrate according to a third embodiment viewed from a lower direction.
FIG. 9 is an exploded perspective view of a filter part according to a first embodiment.
FIG. 10a is a perspective view of a connection pin according to a first embodiment.
FIG. 10b is a perspective view of a connection pin according to a second embodiment.
FIG. 10c is a perspective view of a connection pin according to a third embodiment.
FIG. 11 is a plan view of a state in which a connection pin is coupled to a base according to a first embodiment.
FIG. 12 (a) is a side view of a state in which a connection pin is coupled to a base according to a first embodiment.
FIG. 12 (b) is a cross-sectional view of a state in which a connection pin is coupled to a base according to a first embodiment.
FIG. 13a is a perspective view of a base according to a second embodiment.
FIG. 13b is a perspective view of a base according to a third embodiment.
FIG. 14a is a cross-sectional view of a connection pin, a first terminal part, and a second terminal part according to a first embodiment.
FIG. 14b is a cross-sectional view of a connection pin, a first terminal part, and a second terminal part according to a second embodiment.
FIG. 14c is a cross-sectional view of a connection pin, a first terminal part, and a second terminal part according to a third embodiment.
FIG. 15 is a plan view of a base of a comparative example compared to an embodiment.
FIG. 16 (a) is a side view of a camera module of a comparative example.
FIG. 16 (b) is a side view of a camera module of an embodiment.
FIG. 17 is a mobile terminal to which a camera module according to an embodiment is applied.
FIG. 18 is a perspective view of a vehicle to which a camera module according to the embodiment is applied.

### [Best Mode]

Hereinafter, embodiments of the present disclosure will be described in detail with reference to the accompanying drawings.

However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements. Furthermore, when expressed as "on (over)" or "under (below)", it may include not only an upper direction but also a lower direction based on one element.

An optical axis direction used below may be defined as an optical axis direction of a lens coupled to a camera actuator and a camera module, and a vertical direction may be defined as a direction perpendicular to the optical axis.

The 'optical axis direction' used below is defined as an optical axis direction of a lens module included in the camera module. Meanwhile, the 'optical axis direction' may be used interchangeably with 'vertical direction', 'z-axis direction', etc.

In addition, an 'auto focus function' used below is defined as a function that enables a clear image of a subject to be obtained from an image sensor. For example, the 'auto focus function' is defined as a function that automatically focuses on a subject by adjusting a distance from the image sensor by moving the lens module in the optical axis direction according to the distance of the subject. Meanwhile, 'auto focus' can be used interchangeably with 'AF (Auto Focus)'.

In addition, an 'image stabilization function' used below is defined as a function that moves or tilts the lens module in a direction perpendicular to the optical axis direction to offset vibration (movement) generated in the image sensor due to an external force. Meanwhile, 'image stabilization' can be used interchangeably with 'OIS (Optical Image Stabilization)'.

Before describing an embodiment of the present invention, a configuration of an optical device according to an embodiment will be described.

The optical device may be any one of a mobile phone, a cell phone, a smart phone, a portable smart device, a digital camera, a laptop computer, a digital broadcasting terminal, a PDA (Personal Digital Assistants), a PMP (Portable Multimedia Player), and a navigation device. However, a type of the optical device is not limited thereto, and any device for taking images or pictures may be referred to as an optical device.

The optical device may include a main body (not shown), a camera module, and a display unit (not shown). However, in the optical device, at least one of the main body, the camera module, and the display unit may be omitted or changed.

The main body may form an exterior the optical device. For example, the main body may include a rectangular solid shape. As another example, the main body may be formed to be rounded at least in a portion. The main body may accommodate the camera module. A display unit may be disposed on one surface of the main body. For example, a display unit and a camera module may be disposed on one surface of the main body, and a camera module may be additionally disposed on the other surface of the main body (a surface located opposite the one surface).

The camera module may be disposed in the main body of the optical device. The camera module may be disposed on one surface of the main body. At least a portion of the camera module may be accommodated inside the main body. The camera modules may be provided in multiple numbers. A plurality of camera modules may be disposed on each of the one surface of the main body and the other surface of the main body. The camera module may capture an image of a subject.

The display unit may be disposed on the main body. The display unit may be disposed on one surface of the main body. That is, the display unit may be disposed on a same surface as the camera module. Alternatively, the display unit may be disposed on the other surface of the main body. The display unit may be disposed on a surface of the main body opposite a surface on which the camera module is disposed. The display unit may output an image captured by the camera module.

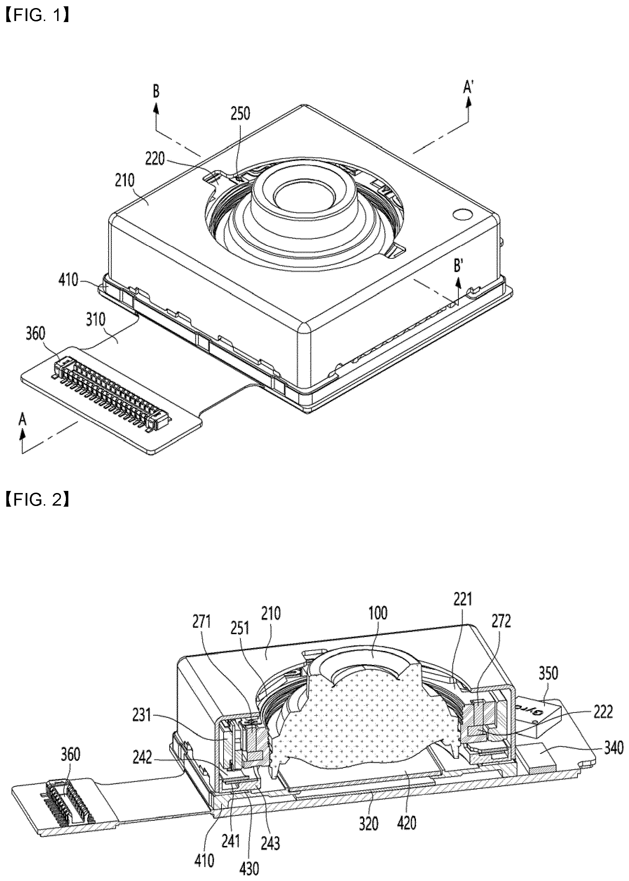

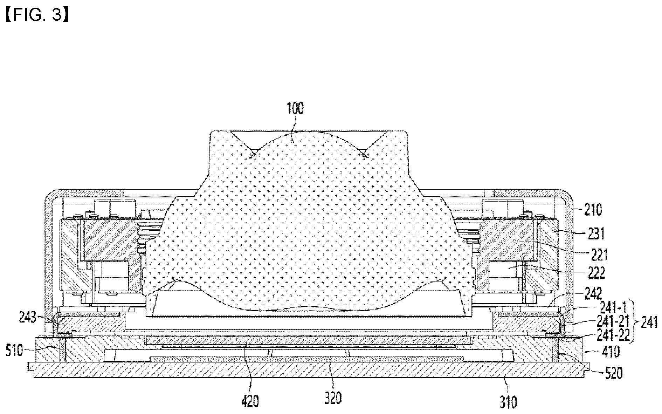

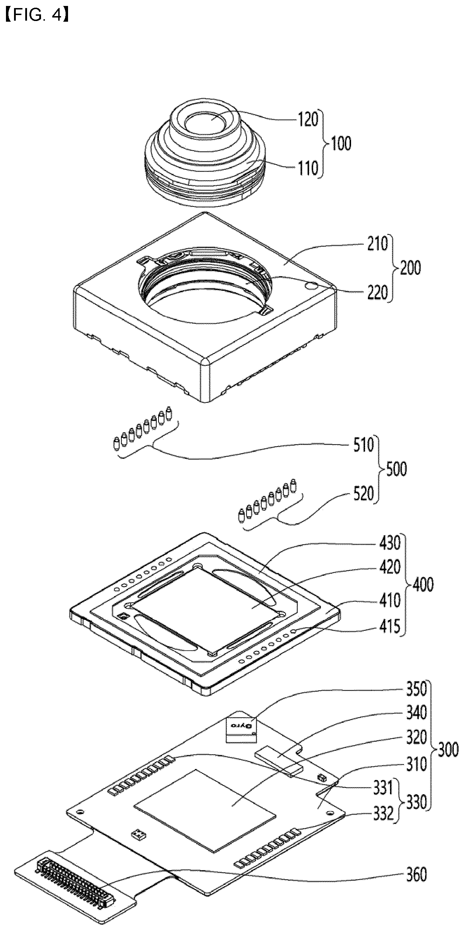

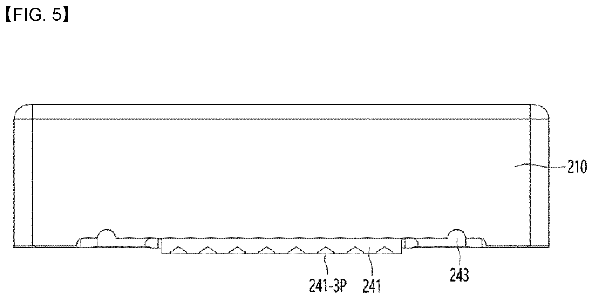

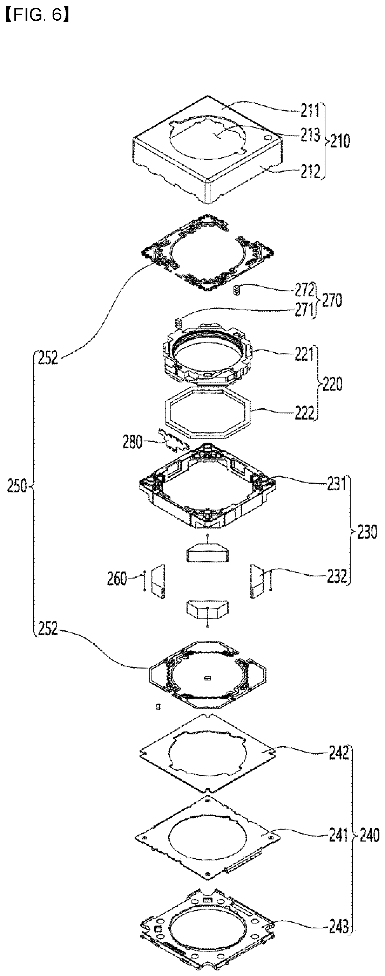

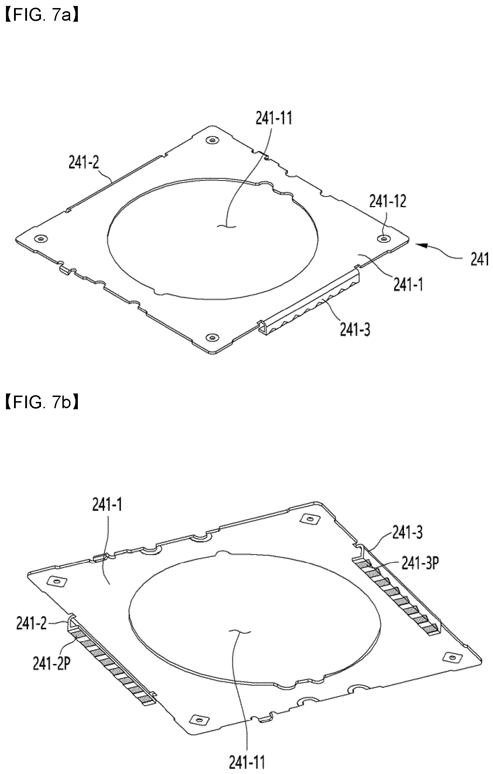

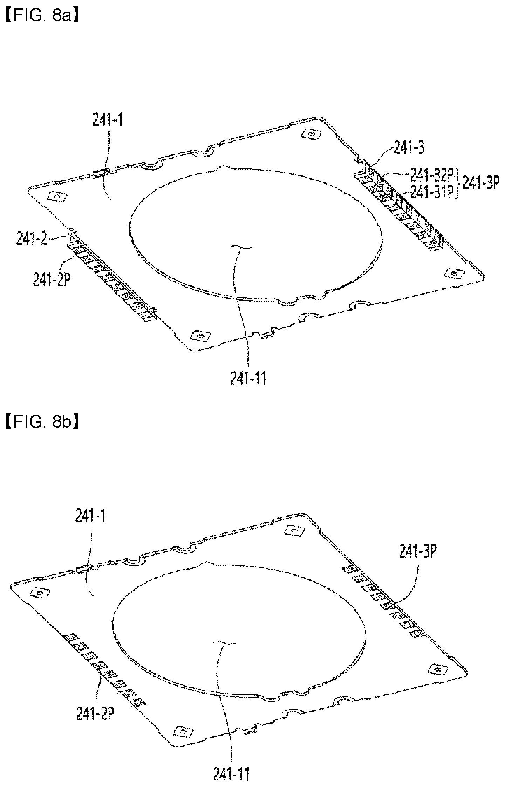

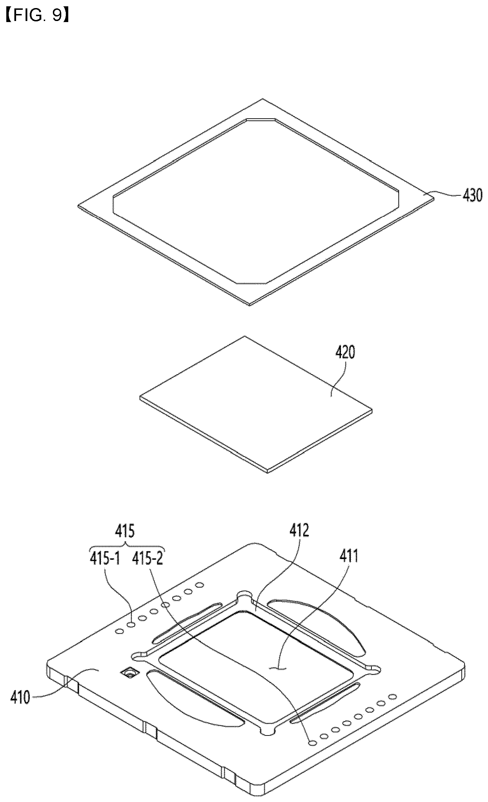

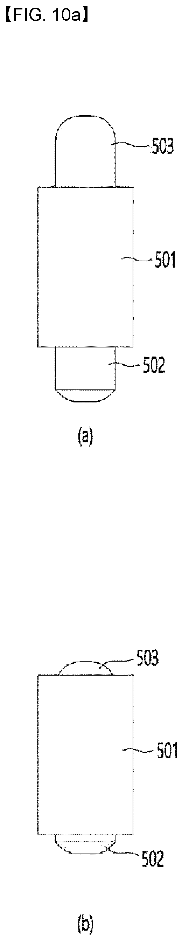

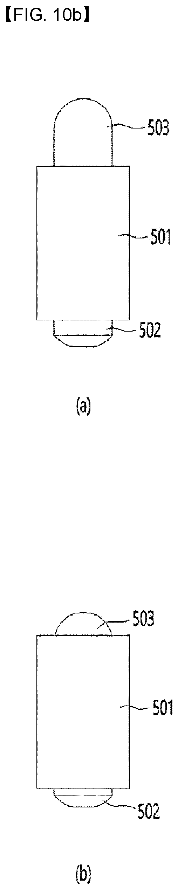

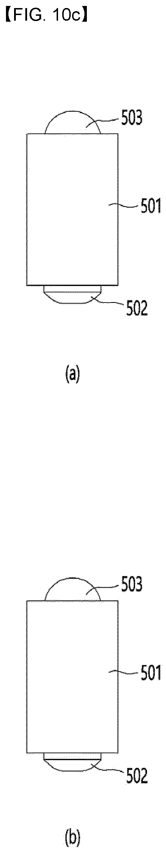

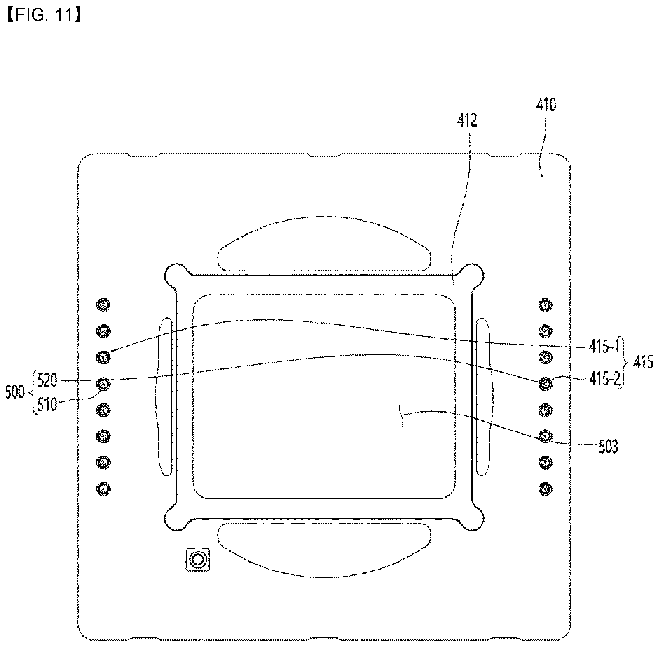

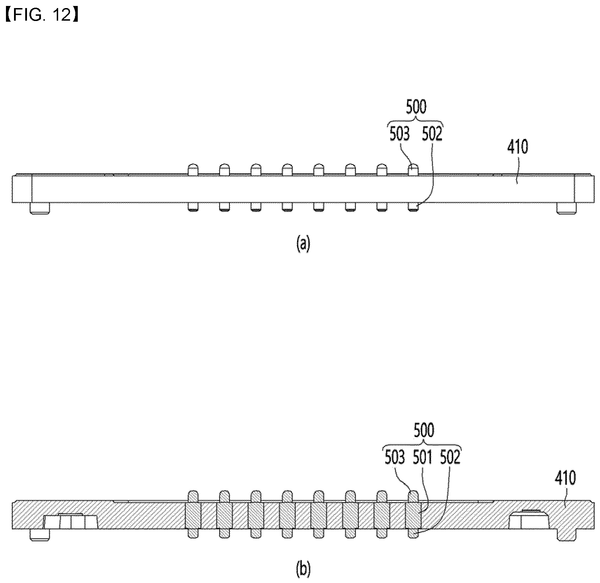

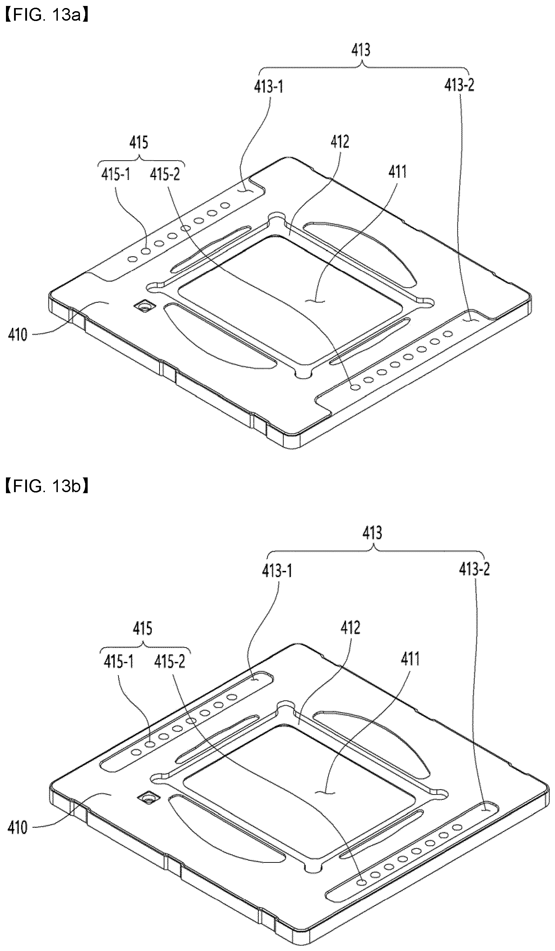

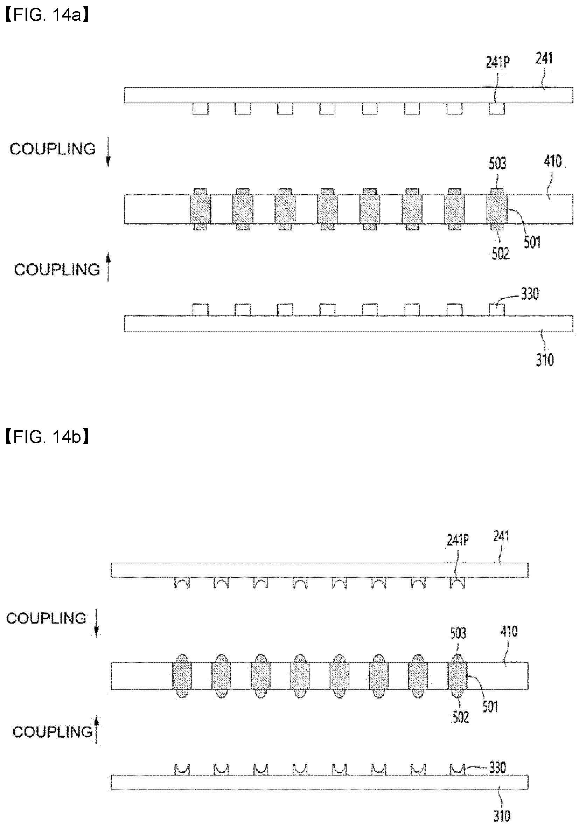

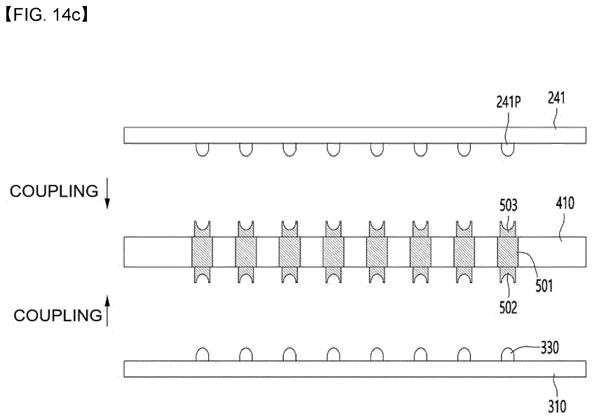

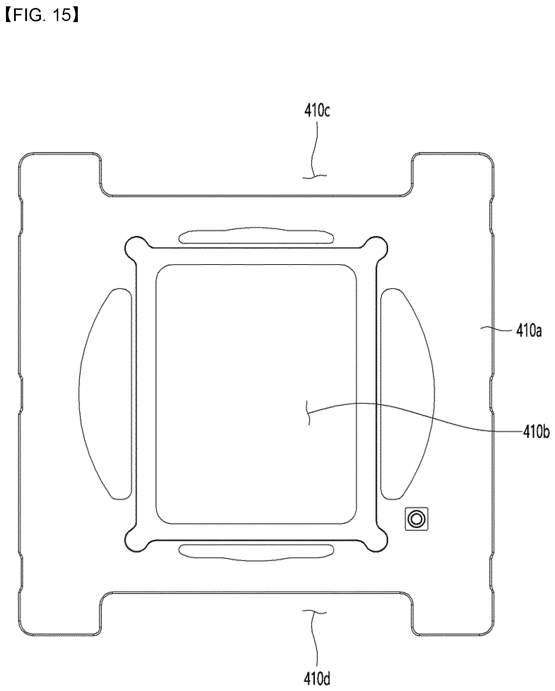

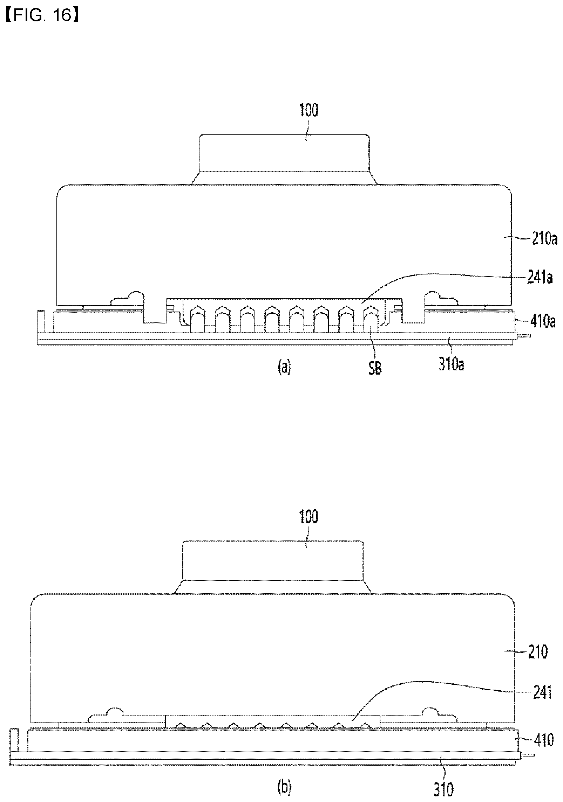

FIG. 1 is a perspective view of a camera module according to an embodiment, FIG. 2 is a cross-sectional view of the camera module of FIG. 1 taken along line A-A', FIG. 3 is a cross-sectional view of the camera module of FIG. 1 taken along line B-B', FIG. 4 is an exploded perspective view of the camera module of FIG. 1, FIG. 5 is a side view of the lens driving device of FIG. 4, FIG. 6 is an exploded perspective view of the lens driving device of FIG. 4, FIG. 7a is a perspective view of a second substrate according to a first embodiment viewed from an upper direction, FIG. 7b is a perspective view of a second substrate according to a first embodiment viewed from a lower direction, FIG. 8a is a perspective view of a second substrate according to a second embodiment viewed from a lower direction, FIG. 8b is a perspective view of a second substrate according to a third embodiment viewed from a lower direction, FIG. 9 is an exploded perspective view of a filter part according to a first embodiment, FIG. 10a is a perspective view of a connection pin according to a first embodiment, FIG. 10b is a perspective view of a connection pin according to a second embodiment, FIG. 10c is a perspective view of a connection pin according to a third embodiment, FIG. 11 is a plan view of a state in which a connection pin is coupled to a base according to a first embodiment, FIG. 12 (a) is a side view of a state in which a connection pin is coupled to a base according to a first embodiment, FIG. 12 (b) is a cross-sectional view of a state in which a connection pin is coupled to a base according to a first embodiment, FIG. 13a is a perspective view of a base according to a second embodiment, FIG. 13b is a perspective view of a base according to a third embodiment, FIG. 14a is a cross-sectional view of a connection pin, a first terminal part, and a second terminal part according to a first embodiment, FIG. 14b is a cross-sectional view of a connection pin, a first terminal part, and a second terminal part according to a second embodiment, FIG. 14c is a cross-sectional view of a connection pin, a first terminal part, and a second terminal part according to a third embodiment, FIG. 15 is a plan view of a base of a comparative example compared to an embodiment, FIG. 16 (a) is a side view of a camera module of a comparative example, and FIG. 16 (b) is a side view of a camera module of an embodiment.

Hereinafter, an overall configuration of the camera module of the embodiment will be described with reference to FIGS. 1 to 16.

Before describing the embodiment, one of a first driving coil 222, a driving magnet 232, and a second driving coil 242 may be referred to as a 'first driving part', the other of the first driving coil 222, the driving magnet 232, and the second driving coil 242 may be referred to as a 'second driving part', and a remaining one of the first driving coil 222, the driving magnet 232, and the second driving coil 242 may be referred to as a 'third driving part'. Meanwhile, the first driving coil 222 may be referred to as a 'AF driving coil', the second driving coil 242 may be referred to as an 'OIS driving coil', and the driving magnet 232 may be referred to as a 'common magnet'. Meanwhile, the first driving coil 222, the driving magnet 232, and the second driving coil 242 may be disposed with their positions swapped with each other.

In addition, the camera module of the embodiment may include a plurality of magnets. One of the plurality of magnets may include the driving magnet 232.

In addition, the camera module may include a sensing magnet 271 and a compensation magnet 272.

At this time, one of the driving magnet 232, the sensing magnet 271, and the compensation magnet 272 may be referred to as a 'first magnet', the other may be referred to as a 'second magnet', and a remaining one may be referred to as a 'third magnet'.

Referring to FIGS. 1 to 4, the camera module of the embodiment may include a lens module 100, a lens driving device 200, a driving substrate part 300, a filter part 400, and a connection pin 500.

The driving substrate part 300 may include a first substrate 310, an image sensor 320, a first terminal part 330, a first device 340, and a second device 350. The first device 340 may be a driver device, and the second device 350 may be a motion sensor. The driving substrate part 300 may also be referred to as a first substrate.

Meanwhile, the camera module of the embodiment is described as including a lens module 100, a lens driving device 200, a driving substrate part 300, a filter part 400, and a connection pin 500, but one or more of these may be omitted or changed.

In addition, the lens module 100 may include a lens 120 and a lens barrel 110. The lens module 100 may include at least one lens 120 and a lens barrel 110 accommodating the lens 120. However, a configuration of the lens module 100 is not limited to the lens barrel 110. For example, the configuration of the lens module 100 can be any holder structure capable of supporting one or more lenses 120.

The lens module 100 may be coupled inside of the lens driving device 200.

The lens module 100 may be coupled to a bobbin 221 of a lens driving device 200. The lens module 100 may be moved together with the bobbin 221 of the lens driving device 200. For example, the lens module 100 may be moved integrally with the bobbin 221 of the lens driving device 200.

As an example, the lens module 100 may be coupled to the bobbin 221 by an adhesive member (not shown). As another example, the lens module 100 may be screw-coupled to the bobbin 221. Meanwhile, light passing through the lens module 100 may be irradiated to an image sensor 320 of the driving substrate part 300.

The filter part 400 may be disposed on the image sensor 320. The filter part 400 may block light in an infrared region from being incident on the image sensor 320. The filter part 400 may include a base 410 and an infrared filter 420. In addition, the filter part 400 may include an adhesive member 430. That is, the adhesive member 430 may be disposed on the base 410. In addition, the infrared filter 420 may be attached or coupled to the base 410 through the adhesive member 430.

The infrared filter 420 may be disposed between the lens module 100 and the image sensor 320. The base 410 of the filter part 400 may be disposed between the lens module 100 and the image sensor 320. In addition, the infrared filter 420 may be mounted on the base 410. For example, the infrared filter 420 may be mounted on a through hole 411 of the base 410. The infrared filter 420 may be formed of a film material or a glass material. The infrared filter 420 may be formed by coating an infrared blocking coating material on a flat optical filter, such as a cover glass for protecting an imaging surface. As an example, the infrared filter 420 may be an infrared absorption filter capable of absorbing infrared rays. As another example, the infrared filter 420 may be an infrared reflection filter capable of reflecting infrared rays. This filter part 400 can be disposed on the driving substrate part 300. Preferably, the filter part 400 can be disposed on the first substrate 310 of the driving substrate part 300.

Meanwhile, the lens driving device 200 can be disposed on the driving substrate part 300 and the filter part 400. Preferably, the lens driving device 200 can be disposed on the filter part 400. For example, the filter part 400 can include an adhesive member 430 disposed on an upper surface of the base 410. In addition, a holder 243 of the lens driving device 200 can be fixed on the filter part 400 through the adhesive member 430. However, the embodiment is not limited thereto.

Preferably, the driving substrate part 300 can be disposed on a lower portion of the filter part 400. In addition, the lens driving device 200 can be disposed on an upper portion of the filter part 400.

The filter part 400 can be coupled to the driving substrate part 300, and the lens driving device 200 can be coupled to the filter part 400.

The driving substrate part 300 can include a first substrate 310. An image sensor 320 can be disposed on the first substrate 310. The first substrate 310 can be electrically connected to the image sensor 320.

At this time, the filter part 400 and the lens driving device 200 can accommodate the image sensor 320 therein. Through this structure, light passing through the lens module 100 coupled to the lens driving device 200 can be irradiated to the image sensor 320 mounted on the first substrate 310 of the driving substrate part 300. The first substrate 310 can supply power (e.g., current) to the lens driving device 200.

Meanwhile, a first device 340, which is a control device for controlling the lens driving device 200, may be disposed on the first substrate 310. In addition, a second device 350, which is a sensing device for determining a control condition of the lens driving device 200, may be disposed on the first substrate 310.

An image sensor 320 may be disposed on the first substrate 310 of the driving substrate part 300. The image sensor 320 may be electrically connected to the first substrate 310. For example, the image sensor 320 may be coupled to the first substrate 310 by surface mounting technology (SMT). As another example, the image sensor 320 may be coupled to the first substrate 310 by flip chip technology. The image sensor 320 may be disposed so that an optical axis of the image sensor 320 is aligned with the lens module 100. That is, an optical axis of the image sensor 320 and an optical axis of the lens module 100 can be aligned. Through this, the image sensor 320 can obtain light passing through the lens module 100. The image sensor 320 can convert light irradiated to an effective image region into an electrical signal. The image sensor 320 can be any one of a CCD (charge coupled device), a MOS (metal oxide semi-conductor), a CPD, and a CID. However, a type of the image sensor 320 is not limited thereto, and the image sensor 320 can include any configuration capable of converting incident light into an electrical signal.

The first device 340 can be disposed on the first substrate 310. For example, the first device 340 can be disposed on an outer side of the lens driving device 200 on the first substrate 310. However, the embodiment is not limited thereto, and the first device 340 may be disposed on an inner side of the lens driving device 200 on the first substrate 310.

The first substrate 310 may include a first terminal part 330. The first terminal part 330 may be disposed on one surface of the first substrate 310. Preferably, the first terminal part 330 may be disposed on an upper surface of the first substrate 310.

The first terminal part 330 may be disposed around the image sensor 320 on the first substrate 310. The first terminal part 330 may include a plurality of first terminals. For example, the first terminal part 330 may include a plurality of first terminals that are electrically connected to the second substrate 241 of the lens driving device 200.

The first terminal part 330 may be divided into a plurality of first terminal groups.

The first terminal part 330 may include a first-first terminal part 331 including a plurality of first-first terminals. The first-first terminal part 331 may be disposed adjacent to one side of the image sensor 320 on the first substrate 310.

The first terminal part 330 may include a first-second terminal part 332 including a plurality of first-second terminals. The first-second terminal part 332 may be disposed adjacent to the other side of the image sensor 320 opposite to the one side on the first substrate 310.

The first-first terminal part 331 and the first-second terminal part 332 may include a same number of terminals. For example, a number of the plurality of first-first terminals may be same as a number of the plurality of first-second terminals. However, the embodiment is not limited thereto. For example, the number of the plurality of first-first terminals may be different from the number of the plurality of first-second terminals. However, the embodiment allows the number of the plurality of first-first terminals to be same as the number of the plurality of first-second terminals. Through this, the embodiment improves a weight balance of the camera module and, accordingly, improves the operability.

For example, the plurality of first-first terminals may include eight terminals. In addition, the plurality of first-second terminals may also include eight terminals.

The plurality of first-first terminals may include power-related terminals, clock terminals, and OIS driving terminals. In addition, the plurality of first-second terminals may include hall sensor terminals and ground terminals. For example, the first substrate 310 may be connected to the second driving coil 242 disposed on the second substrate 241. At this time, the second driving coil 242 may include a second-first driving coil (not shown) for driving in a x-axis direction and a second-second driving coil (not shown) for driving in a y-axis direction. In addition, the lens driving device 200 may include a first sensor unit (not shown) and a second sensor unit (not shown) for detecting a position of the housing 231 or the bobbin 221.

In addition, the plurality of first-first terminals of the first-first terminal part 331 may include a first-first-a terminal connected to one end of the second-first driving coil, a first-first-b terminal connected to another end of the second-first driving coil, a first-first-c terminal connected to one end of the second-second driving coil, a first-first-d terminal connected to another end of the second-second driving coil, a first-first-e terminal corresponding to an SDA terminal transmitting a data signal, a first-first-f terminal corresponding to an SCL terminal transmitting a clock signal, a first-first-g terminal transmitting a VDD power, and a first-first-h terminal transmitting a VSS power.

In addition, the plurality of first-second terminals of the first-second terminal part 332 may include a first-second-a terminal connected to a first input terminal of the first sensor unit, a first-second-b terminal connected to a first output terminal (e.g., positive terminal) of the first sensor unit, a first-second-c terminal connected to a second output terminal (e.g., negative terminal) of the first sensor unit, a first-second-d terminal connected to a first input terminal of the second sensor unit, a first-second-e terminal connected to a first output terminal (e.g., positive terminal) of the second sensor unit, a first-second-f terminal connected to a second output terminal (e.g., negative terminal) of the second sensor unit, a first- second-g terminal commonly connected to second input terminals of the first and second sensor units, and a first-second-h terminal for frame ground.

The first terminal part 330 may be formed of a metal material having high electrical conductivity to transmit an electrical signal. For example, the first terminal part 330 may be formed of at least one metal material selected from gold (Au), silver (Ag), platinum (Pt), titanium (Ti), tin (Sn), copper (Cu), and zinc (Zn). For example, the first terminal part 330 may be formed of copper (Cu) which has high electrical conductivity and is relatively inexpensive. The first terminal part 330 may be formed by a conventional manufacturing process of a printed circuit board, such as an additive process, a subtractive process, a modified semi-additive process (MSAP), and a semi-additive process (SAP).

The first device 340 may also be referred to as a 'driving device' or a 'control device' or a 'control unit' that drives or controls the lens driving device 200.

The first device 340 can individually control directions, intensities, and amplitudes of currents supplied to the first driving coil 222 and the second driving coil 242 of the lens driving device 200. However, the intensity of the current supplied to the first driving coil 222 can be controlled by a hall driver device (not shown).

The first device 340 can control the lens driving device 200 to perform at least one of an auto focus function and an image stabilization function of the camera module. That is, the first device 340 can control the lens driving device 200 to move the lens module 100 in an optical axis direction, move the lens module 100 in a direction perpendicular to the optical axis direction, or tilt the lens module 100. Furthermore, the first device 340 can perform at least one of the feedback control of the auto focus function and the feedback control of the image stabilization function.

For example, the first device 340 can receive a position of the bobbin 221 or the housing 231 detected by the first sensor unit (not shown) and control the current applied to the first driving coil 222. Through this, the first device 340 can perform autofocus feedback control. In addition, the first device 340 can receive a position of the bobbin 221 or the housing 231 detected by the second sensor unit (not shown) and control the current applied to the second driving coil 242. Through this, the first device 340 can perform image stabilization feedback control.

At this time, the feedback control by the first device 340 occurs in real time, and thereby a more precise autofocus function and image stabilization function can be performed.

The second device 350 can be disposed on the first substrate 310 and spaced apart from the first device 340. The second device 350 may be a motion sensor. For example, the second device 350 may detect rotational angular velocity information due to a movement of the camera module. The second device 350 may be implemented as a two-axis or three-axis gyro sensor or an angular velocity sensor.

In addition, the driving substrate part 300 may include a connector 360. The connector 360 may be disposed on the first substrate 310. For example, the connector 360 may be electrically connected to the first substrate 310. The connector 360 may include a port electrically connected to an external device (e.g., an optical device). The connector 360 may transmit an image signal acquired from the image sensor 320 to an optical device. In addition, the connector 360 can transmit a signal transmitted from the optical device to the first device 340 disposed on the first substrate 310.

A connection pin 500 can be coupled to the filter part 400. For example, the connection pin 500 can penetrate the base 410 of the filter part 400. The connection pin 500 can include a first connection part 502 connected to the first substrate 310 of the driving substrate part 300. In addition, the connection pin 500 can include a second connection part 503 connected to the second substrate 241 of the lens driving device 200.

For example, the driving substrate part 300 and the lens driving device 200 can be electrically connected to each other. For example, the first substrate 310 of the driving substrate part 300 and the second substrate 241 of the lens driving device 200 may be electrically connected to each other.

At this time, the camera module of the embodiment may electrically connect the first substrate 310 and the second substrate 241 using the connection pin 500. In addition, the connection pin 500 is disposed to penetrate the base 410 of the filter part 400. In addition, the connection pin 500 may be electrically connected to the first substrate 310 through the first connection part 502 and electrically connected to the second substrate 241 through the second connection part 503 while penetrating the base 410.

Specifically, the first substrate 310 may include a first terminal part 330. In addition, the lens driving device 200 may include a second substrate 241 having a second terminal part (241P, see FIGS. 14a to 14c).

At this time, in the camera module of a comparative example, the first terminal part 330 and the second terminal part 241P are mutually connected by soldering.

In contrast, in the embodiment, the first substrate 310 and the second substrate 241 may be electrically connected to each other through a connection pin 500 penetrating the base 410. For example, the first connection part 502 of the connection pin 500 may be in contact with the first terminal part 330 of the first substrate 310, and the second connection part 503 of the connection pin 500 may be in contact with the second terminal part 241P of the second substrate 241. Accordingly, a point of contact with the second connection part 503 of the connection pin 500 in the second terminal part 241P may be disposed on the second substrate 241 in a horizontal direction rather than a vertical direction. For example, as shown in FIG. 5, when viewed from a side surface of the camera module, a portion of the second terminal part 241P that substantially contacts the second connection part 503 among an entire region of the second terminal part 241P may be located on a lower portion of the second substrate 241. In contrast, a contact portion in the comparative example was located on a side portion of the second substrate. This can be achieved by a fact that the camera module of the embodiment is mutually coupled between the first substrate 310 and the second substrate 241 by the connection pin 500, and thus a soldering process in the comparative example is omitted.

Hereinafter, the lens driving device 200, the driving substrate part 300, the filter part 400, and the connection pin 500 of the embodiment will be described in more detail.

Referring to FIG. 6, the lens driving device 200 may include a cover member 210, a first mover 220, a second mover 230, a stator 240, a first support member 250, a second support member 260, and sensor units (not shown).

However, in the lens driving device 200, one or more of the cover member 210, the first mover 220, the second mover 230, the stator 240, the first support member 250, the second support member 260, and the sensor units may be omitted or changed. In particular, one or more of the sensor units may be omitted as a configuration for auto focus feedback control and image stabilization feedback control.

The cover member 210 may form an exterior of the lens driving device 200. The cover member 210 may have a hexahedral shape with an open bottom. However, a shape of the cover member 210 is not limited thereto. The cover member 210 may be a non-magnetic material. If the cover member 210 is provided with a magnetic material, a magnetic force of the cover member 210 may affect one or more of the driving magnet 232, the sensing magnet 271, and the compensation magnet 272. The cover member 210 may be formed of a metal material.

The cover member 210 may be provided with a metal plate. In this case, the cover member 210 may block electromagnetic interference (EMI). Accordingly, the cover member 210 may be referred to as an 'EMI shield-can'. The cover member 210 may block radio waves generated outside the lens driving device 200 from flowing into the inside of the cover member 210. In addition, the cover member 210 can block radio waves generated inside the cover member 210 from being emitted outside the cover member 210.

The cover member 210 may include an upper plate 211 and a side plate 212. The cover member 210 may include an upper plate 211 and a side plate 212 extending downward from an outer periphery of the upper plate 211. The cover member 210 may be coupled to a holder 243. A portion of the side plate 212 of the cover member 210 may be coupled to the holder 243.

An inner surface of the side plate 212 of the cover member 210 may be in direct contact with an outer surface of the holder 243. The inner surface of the side plate 212 of the cover member 210 may be coupled to the holder 243 by an adhesive (not shown).

A first mover 220, a second mover 230, a stator 240, a first support member 250, and a second support member 260 can be disposed in an internal space formed by the cover member 210 and the holder 243. Through this structure, the cover member 210 can protect internal components from external impact while preventing a penetration of external contaminants.

The cover member 210 can include an opening part 213. The opening part 213 can be provided on the upper plate 211 of the cover member 210. The opening part 213 can expose the lens module 100 upward. The opening part 213 can be formed in a shape corresponding to the lens module 100. A size of the opening part 213 may be larger than a diameter of the lens module 100 so that the lens module 100 can be assembled through the opening part 213. Light introduced through the opening part 213 may pass through the lens module 100. At this time, the light passing through the lens module 100 may be converted into an electrical signal in the image sensor and acquired as an image.

The first mover 220 may be coupled with the lens module 100. The first mover 220 may accommodate the lens module 100 therein. An outer periphery surface of the lens module 100 may be coupled to an inner periphery surface of the first mover 220. The first mover 220 may move through interaction with the second mover 230 and/or the stator 240. At this time, the first mover 220 can move integrally with the lens module 100. Meanwhile, the first mover 220 can move for the auto focus function. At this time, the first mover 220 can be referred to as an 'AF mover'. However, this is not limited to the first mover 220 being a member that moves only for the auto focus function. The first mover 220 can also move for the image stabilization function.

The first mover 220 can include a bobbin 221 and a first driving coil 222. However, at least one of the bobbin 221 and the first driving coil 222 of the first mover 220 can be omitted or changed.

The bobbin 221 can be disposed inside the housing 231. The bobbin 221 can be disposed in a through hole (not shown) of the housing 231.

The bobbin 221 can move in an optical axis direction based on the housing 231. The bobbin 221 can be disposed to move along the optical axis in a through hole (not shown) of the housing 231. The bobbin 221 can be coupled with the lens module 100. An inner periphery surface of the bobbin 221 can be coupled with an outer periphery surface of the lens module 100. The first driving coil 222 can be coupled to the bobbin 221. The outer periphery surface of the bobbin 221 can be coupled with the first driving coil 222. A lower portion of the bobbin 221 can be coupled with a lower support member 252. An upper portion of the bobbin 221 can be coupled with an upper support member 251.

The bobbin 221 can include a through hole (not shown). In addition, the lens module 100 can be disposed in the through hole of the bobbin 221. For example, the lens module 100 can be screw-coupled to the through hole of the bobbin 221. Alternatively, the lens module 100 can be coupled to the through hole of the bobbin 221 by an adhesive.

The first driving coil 222 can be coupled to the bobbin 221. For this purpose, the bobbin 221 can include a groove (not shown) in which a part of an outer periphery surface of the bobbin is recessed inward. In addition, the first driving coil 222 can be accommodated in the groove.

An upper support member 251 can be coupled to an upper surface of the bobbin 221. For this purpose, a coupling protrusion (not shown) to which the upper support member 251 is coupled can be formed on an upper side of the bobbin 221.

In addition, a lower support member 252 may be coupled to a lower surface of the bobbin 221.

The first driving coil 222 may be disposed on the bobbin 221. The first driving coil 222 may be disposed on an outer periphery surface of the bobbin 221. The first driving coil 222 may be directly wound on the bobbin 221. The first driving coil 222 may face the driving magnet 232. In this case, when current is supplied to the first driving coil 222 and a magnetic field is formed around the first driving coil 222, the first driving coil 222 may move relative to the driving magnet 232 due to an electromagnetic interaction between the first driving coil 222 and the driving magnet 232. The first driving coil 222 may electromagnetically interact with the driving magnet 232. The first driving coil 222 can move the bobbin 221 in the optical axis direction with respect to the housing 231 through electromagnetic interaction with the driving magnet 232. As an example, the first driving coil 222 can be a single coil formed integrally. As another example, the first driving coil 222 can include a plurality of coils spaced apart from each other.

The first driving coil 222 can include a pair of lead lines for power supply. At this time, the pair of lead lines of the first driving coil 222 can be electrically connected to the upper support member 251. That is, the first driving coil 222 can be supplied with power through the upper support member 251. As another example, the pair of lead lines of the first driving coil 222 can be electrically connected to the lower support member 252.

The second mover 230 can accommodate at least a part of the first mover 220 therein. The second mover 230 can move the first mover 220 or move together with the first mover 220. The second mover 230 can move through interaction with the stator 240. The second mover 230 can move for the image stabilization function. At this time, the second mover 230 can be called an 'OIS mover'. The second mover 230 can move integrally with the first mover 220 when moving for the image stabilization function.

The second mover 230 can include a housing 231 and a driving magnet 232. However, at least one of the housing 231 and the driving magnet 232 of the second mover 230 can be omitted or changed.

The housing 231 may be disposed on an outer side of the bobbin 221. The housing 231 may accommodate at least a portion of the bobbin 221 therein. For example, the housing 231 may include a hexahedral shape. The housing 231 may include four side surfaces and four corner portions disposed between the four side surfaces. A driving magnet 232 may be disposed on the housing 231. For example, a driving magnet 232 may be disposed on each of the four side surfaces of the housing 231. As another example, a driving magnet 232 may be disposed on each of the four corner portions of the housing 231. At least a portion of the outer surface of the housing 231 may be formed in a shape corresponding to the inner surface of the cover member 210. In particular, the outer surface of the housing 231 may be formed in a shape corresponding to the inner surface of the side plate 212 of the cover member 210. The housing 231 may be formed of an insulating material. The housing 231 may be formed of a material different from that of the cover member 210.

An upper support member 251 may be coupled to an upper portion of the housing 231. A lower support member 252 may be coupled to a lower portion of the housing 231.

In addition, a first sensor unit and/or a second sensor unit may be disposed in the housing 231.

For example, a first sensor unit 270 may include a sensing magnet 271, a compensation magnet 272, and a first Hall sensor (not shown).

A driving magnet 232 may be disposed in the housing 231. The driving magnet 232 may be disposed on an outer side of the first driving coil 222. The driving magnet 232 may face the first driving coil 222. The driving magnet 232 may electromagnetically interact with the first driving coil 222. The driving magnet 232 may be disposed on an upper side of the second driving coil 242. The driving magnet 232 may face the second driving coil 242. The driving magnet 232 may electromagnetically interact with the second driving coil 242. The driving magnet 232 may be commonly used for the auto focus function and the image stabilization function. However, the driving magnet 232 may include a plurality of magnets that are separately used for each of the auto focus function and the image stabilization function. As an example, the driving magnet 232 may be disposed on a side surface of the housing 231. In this case, the driving magnet 232 may be a flat magnet. The driving magnet 232 may have a flat plate shape. As another example, the driving magnet 232 may be disposed on a corner portion of the housing 231. At this time, the driving magnet 232 may be a corner magnet. The driving magnet 232 may have a hexahedral shape in which an inner side surface is wider than an outer side surface. The driving magnet 232 may include a plurality of magnets spaced apart from each other. The driving magnet 232 may include four magnets spaced apart from each other. In this case, four magnets may be disposed in the housing 231 such that two neighboring magnets form 90° with each other. That is, the driving magnet 232 may be disposed on four side surfaces of the housing 231 at a same interval.

The stator 240 may be disposed on a lower side of the housing 231. The stator 240 may be disposed on a lower side of the second mover 230.

The stator 240 may face the second mover 230. The stator 240 can movably support the second mover 230. The stator 240 can move the second mover 230. At this time, the first mover 220 can also move together with the second mover 230.

The stator 240 can include a second substrate 241, a second driving coil 242, and a holder 243. However, in the stator 240, at least one of the second substrate 241, the second driving coil 242, and the holder 243 can be omitted or changed. The stator 240 can also be referred to as a second substrate part.

The second substrate 241 can supply power to the second driving coil 242. The second substrate 241 can be coupled with the second driving coil 242. The second substrate 241 can be coupled with the base 410 of the filter part 400 that is disposed on a lower side of the holder 243. The second substrate 241 can be disposed on a lower surface of the second driving coil 242. The second substrate 241 can be disposed on an upper surface of the holder 243. The second substrate 241 can be disposed between the second driving coil 242 and the holder 243.

The second substrate 241 can include a flexible printed circuit board (FPCB).

The second substrate 241 can have different structures or shapes according to an embodiment.

First, the second substrate 241 of a first embodiment will be described as follows.

Referring to FIGS. 7a and 7b, the second substrate 241 may include a portion bent in at least a portion thereof.

For example, the second substrate 241 may include a first region 241-1. The first region 241-1 may be a flat region. The first region 241-1 may be a rigid region. The first region 241-1 of the second substrate 241 may be disposed on the holder 243.

The first region 241-1 may include an opening part 241-11. The opening part 241-11 may be aligned with the lens module 100 and the image sensor 320 along an optical axis. For example, the opening part 241-11 may be formed on a central portion of the first region 241-1 of the second substrate 241. The opening part 241-11 may be formed to penetrate the first region 241-1 of the second substrate 241. The opening part 241-11 can pass light that has passed through the lens module 100. The opening part 241-11 can be formed in a circular shape, but is not limited thereto.

The first region 241-1 of the second substrate 241 can include at least one through hole 241-12. The through hole 241-12 can penetrate the first region 241-1. The through hole 241-12 can include a plurality of through holes. The through holes 241-12 can be formed in each corner region of an upper surface of the first region 241-1 of the second substrate 241. The through hole 241-12 can be a through hole through which the second support member 260 passes.

The second substrate 241 may include a second region bent from the first region 241-1.

For example, the second substrate 241 may include a second region that is bent at least one end of the first region 241-1. The second region may include a plurality of bending regions that are each bent at different ends of the first region 241-1.

The second region of the second substrate 241 may include a first bending region 241-2 bent in a lower direction from one end of the first region 241-1. In addition, the second region of the second substrate 241 may include a second bending region 241-3 bent in a lower direction from the other end opposite to the one end of the first region 241-1.

In addition, a second terminal part may be formed in the second region of the second substrate 241. The second terminal part can be electrically connected to the first terminal part 330 of the first substrate 310. For example, the second terminal part of the second substrate 241 can be electrically connected to the first terminal part 330 of the first substrate 310 via the connection pin 500.

At this time, the second region of the second substrate 241 may be divided into a plurality of sub-regions. For example, the second region of the second substrate 241 may include a first sub-region (241-21, see FIG. 3) bent from the first region 241-1 and penetrating the holder 243. However, the embodiment is not limited thereto. For example, the first sub-region 241-21 of the second region of the second substrate 241 may not penetrate the holder 243 but may be disposed on a side portion of the holder 243.

In addition, the second region of the second substrate 241 may include a second sub-region (241-22, see FIG. 3) bent from the first sub-region 241-21 and disposed below the holder 243. That is, the first sub-region 241-21 may penetrate the holder 243 or be disposed on a side portion of the holder 243.

For example, each of the first bending region 241-2 and the second bending region 241-3 of the second substrate 241 may include the first sub-region 241-21 and the second sub-region 241-22.

The second sub-regions 241-22 of each of the first bending region 241-2 and the second bending region 241-3 may face the first region 241-1. For example, an upper surface of each of the second sub-regions 241-22 of the first bending region 241-2 and the second bending region 241-3 may face a lower surface of the first region 241-1.

In addition, the second terminal part of the first embodiment may be disposed on a lower surface of the second sub-region 241-22 of the second region. For example, the second terminal part may be disposed to face an upper surface of the base 410 of the filter part 400.

The second terminal part may include a second-first terminal part 241-2P disposed on a lower surface of the second sub-region of the first bending region 241-2. The second-first terminal part 241-2P may correspond to the first-first terminal part 331 of the first terminal part 330. Accordingly, a number of the second-first terminal parts 241-2P may correspond to a number of the first-first terminal parts 331, but is not limited thereto. The second-first terminal part 241-2P may include a plurality of second-first terminals connected to a plurality of first-first terminals of the first-first terminal part 331 of the first substrate 310.

The second terminal part may include a second-second terminal part 241-3P disposed on a lower surface of the second sub-region of the second bending region 241-3. The second-second terminal part 241-3P may correspond to the first-second terminal part 332 of the first terminal part 330. Accordingly, a number of the second-second terminal parts 241-3P may correspond to a number of the first-second terminal parts 332, but is not limited thereto. The second-second terminal part 241-3P may include a plurality of second-second terminals connected to a plurality of first-second terminals of the first-second terminal part 332 of the first substrate 310.

In addition, the second terminal part of the second substrate 241 may be electrically connected to the first terminal part 330 of the first substrate 310 by a connection pin 500 to be described later.

Meanwhile, referring to FIG. 8a, the second substrate 241 in another embodiment may have a different structure in the second terminal part from the first embodiment of FIGS. 7a and 7b.

That is, the second terminal part may include a plurality of portions.

For example, the second-first terminal part 241-2P may include a plurality of portions. In addition, the second-second terminal part 241-3P may include a plurality of portions. Hereinafter, a description will be based on the second-second terminal part 241-3P. In addition, the second-first terminal part 241-2P may have a same structure as the second-second terminal part 241-3P described below.

The second-second terminal part 241-3P may include a first portion 241-31P and a second portion 241-32P.

The first portion 241-31P of the second-second terminal part 241-3P may be disposed in the second bending region 241-3 of the second substrate 241. For example, the first portion 241-31P of the second-second terminal part 241-3P may be disposed under the second sub-region 241-22 of the second bending region 241-3 of the second substrate 241. The first portion 241-31P of the second-second terminal part 241-3P may be a portion in contact with the second connection part 503 of the connection pin 500. For example, the first portion 241-31P of the second-second terminal part 241-3P may be a contact terminal in contact with the second connection part 503.

In addition, the second portion 241-32P of the second-second terminal part 241-3P may be disposed in the first sub-region 241-21 of the second bending region 241-3 of the second substrate 241. For example, the second portion 241-32P of the second-second terminal part 241-3P may be disposed on a side portion of the first sub-region 241-21. The second portion 241-32P of the second-second terminal part 241-3P can be connected to the first portion 241-31P of the second-second terminal part 241-3P. That is, the first portion 241-31P and the second portion 241-32P can be one terminal pattern, and can be distinguished only by an arrangement position. The second portion 241-32P of the second-second terminal part 241-3P can be exposed to the outside of the camera module. At this time, when the second bending region 241-3 penetrates the holder 243, a side portion of the holder 243 may include a recess (not shown) that horizontally overlaps the second portion 241-32P of the second-second terminal part 241-3P and exposes the second portion 241-32P to the outside of the camera module. The second portion 241-32P of the second-second terminal part 241-3P may be utilized as a test terminal. For example, in order to couple the second substrate 241 of the lens driving device 200 with the filter part 400 coupled on the first substrate 310 to which the image sensor 320 is attached, an active align (AA: Active Align) process must be performed to accurately focus the lens of the lens driving device 200 on the image sensor 320. In addition, the second portion 241-32P of the second-second terminal part 241-3P can be connected to a gripper during the active align process, and thereby can be utilized as a terminal for adjusting a position of the lens driving device 200. Meanwhile, when the active align process is completed, the second portion 241-32P of the second-second terminal part 241-3P may not be used. Meanwhile, when the active align process is completed, the second portion 241-32P of the second-second terminal part 241-3P may be covered with a separate insulating member (not shown). However, the embodiment is not limited thereto. For example, the second portion 241-32P of the second-second terminal part 241-3P may be exposed to the outside of the camera module even after the active align process is completed. In addition, the exposed second portion 241-32P can be used as a terminal for testing a contact reliability between the first terminal part 330 of the first substrate 310 and the second terminal part of the second substrate 241 connected through the connection pin 500 in the usage environment of the camera module.

Meanwhile, referring to FIG. 8b, the second substrate 241 in another embodiment may have a structure different from the first and second embodiments of FIGS. 7a, 7b and 8a in that it does not include a bending region.

Specifically, the second substrate 241 may include only the first region 241-1 in the structure of the first embodiment. For example, the second substrate 241 may not include a bending region that is bent in a lower direction from an end of the first region 241-1. In addition, the second terminal part may be disposed on a lower surface of the first region 241-1 of the second substrate 241. At this time, a holder 243 may be disposed on a lower portion of the second substrate 241. Accordingly, the holder 243 may include an opening (not shown) that vertically overlaps the second terminal part disposed on a lower surface of the first region 241-1 of the second substrate 241. The second connection part 503 of the connection pin 500 may be at least partially disposed within the opening of the holder 243. Through this, the second connection part 503 may be in contact with or electrically connected to the second terminal part disposed on a lower surface of the first region 241-1 of the second substrate 241 through the opening of the holder 243. Meanwhile, the second terminal part provided on the second substrate 241 of the third embodiment may also include a first portion and a second portion corresponding to the second embodiment. In this case, the first portion of the second terminal part may be provided on a lower surface of the first region 241-1, and the second portion of the second terminal part may be provided on a side surface of the first region 241-1.

Again, referring to FIG. 6, the second driving coil 242 may be disposed on the holder 243. The second driving coil 242 may be disposed on the second substrate 241. The second driving coil 242 may be disposed on the upper surface of the second substrate 241. The second driving coil 242 may be disposed on a lower side of the driving magnet 232. The second driving coil 242 may be disposed between the driving magnet 232 and the holder 243. The second support member 260 may be coupled to the second driving coil 242. The second driving coil 242 can movably support the second mover 230. At this time, although not shown in the drawing, the second driving coil 242 may include a substrate and a coil portion disposed on the substrate.

The second driving coil 242 may receive power through the first substrate 310, the connection pin 500, and the second substrate 241. The second driving coil 242 may face the driving magnet 232. In this case, when current is supplied to the second driving coil 242 and a magnetic field is formed around the second driving coil 242, the driving magnet 232 may move relative to the second driving coil 242 due to the electromagnetic interaction between the second driving coil 242 and the driving magnet 232. The second driving coil 242 may electromagnetically interact with the driving magnet 232. The second driving coil 242 can move the housing 231 and the bobbin 221 in a direction perpendicular to the optical axis with respect to the holder 243 through electromagnetic interaction with the driving magnet 232.

The first supporting member 250 can be coupled to the bobbin 221 and the housing 231. The first supporting member 250 can elastically support the bobbin 221. The first support member 250 may have elasticity in at least a portion thereof. At this time, the first supporting member 250 can be referred to as a 'first elastic member'. The first supporting member 250 can movably support the bobbin 221. The first supporting member 250 can support the bobbin 221 to be movable in the optical axis direction with respect to the housing 231. That is, the first support member 250 can support the bobbin 221 to drive the AF. At this time, the first support member 250 can be referred to as an 'AF support member'. The first support member 250 can include an upper support member 251 and a lower support member 252. However, in the first support member 250, at least one of the upper support member 251 and the lower support member 252 can be omitted or changed.

The upper support member 251 is disposed at an upper side of the bobbin 221 and can be coupled to the bobbin 221 and the housing 231. The upper support member 251 can be coupled to the bobbin 221 and the housing 231. The upper support member 251 can be coupled to an upper portion of the bobbin 221 and an upper portion of the housing 231. The upper support member 251 can elastically support the bobbin 221. The upper support member 251 can have elasticity in at least a portion thereof. In this case, the upper support member 251 can be called an 'upper elastic member'. The upper support member 251 can movably support the bobbin 221. The upper support member 251 can support the bobbin 221 to be movable in the optical axis direction with respect to the housing 231. The upper support member 251 can be formed as a plate spring.

The lower support member 252 is disposed on a lower side of the bobbin 221 and can be coupled to the bobbin 221 and the housing 231. The lower support member 252 can be coupled to the bobbin 221 and the housing 231. The lower support member 252 can be coupled to a lower portion of the bobbin 221 and a lower portion of the housing 231. The lower support member 252 can elastically support the bobbin 221. The lower support member 252 can have elasticity in at least a portion thereof. In this case, the lower support member 252 can be called a 'lower elastic member'. The lower support member 252 can movably support the bobbin 221. The lower support member 252 can support the bobbin 221 to be movable in the optical axis direction with respect to the housing 231. The lower support member 252 can be formed as a plate spring.

The second support member 260 can movably support the housing 231. The second support member 260 can elastically support the housing 231. The second support member 260 may have elasticity in at least a portion thereof. At this time, the second support member 260 may be referred to as a 'second elastic member'. For example, the second support member 260 may support the housing 231 to be movable in a direction perpendicular to the optical axis with respect to the stator 240. At this time, the bobbin 221 may move integrally with the housing 231. As another example, the second support member 260 may support the housing 231 so that it can tilt with respect to the stator 240. That is, the second support member 260 may support the housing 231 and the bobbin 221 so that they drive the OIS. At this time, the second support member 260 may be referred to as an 'OIS support member'. For example, the second support member 260 may be formed of a wire.

The first sensor unit 270 may be provided for auto focus feedback. The first sensor unit 270 may detect movement of the bobbin 221 in the optical axis direction. The first sensor unit 270 may detect an amount of movement of the bobbin 221 in the optical axis direction and provide the detected amount to the first device 340 in real time. The first sensor unit 270 may include a first hall sensor (not shown), a sensing magnet 271, and a compensation magnet 272.

In addition, the camera module may further include a second sensor unit (not shown). The second sensor unit may include a second Hall sensor. The second sensor unit may be provided for image stabilization feedback. In this case, the second sensor unit may be referred to as an 'OIS feedback sensor'. The second sensor unit may detect movement of the housing 231. The second sensor unit may detect movement or tilt in a direction perpendicular to the optical axis of the housing 231 and/or the bobbin 221. The second sensor unit may detect the driving magnet 232. The second sensor unit may detect the driving magnet 232 disposed in the housing 231. The second sensor unit may detect a position of the housing 231. The second sensor unit may detect an amount of movement in a direction perpendicular to the optical axis of the housing 231.

The lens driving device 200 may further include a third substrate 280. The third substrate 280 may be electrically connected to the second substrate 241. For example, the third substrate 280 may be electrically connected to the first driving coil 222. The third substrate 280 may supply power to the first driving coil 222. At this time, the third substrate 280 may be electrically connected to at least one of the first support member 250 and the second support member 260. Accordingly, power provided from the second substrate 241 to the third substrate 280 may be supplied to the first driving coil 222 via at least one of the first support member 250 and the second support member 260.

As described above, the lens driving device 200 may include the second substrate 241. In addition, the second terminal part of the second substrate 241 may be disposed facing an upper surface of the base 410 of the filter part 400 to be described later.

Meanwhile, an overall structure of the filter part 400 will be described with reference to FIGS. 9 to 12.

Referring to FIGS. 9 to 12, the filter part 400 may include a base 410, an infrared filter 420, and an adhesive member 430.

The base 410 may be disposed under the lens driving device 200. For example, at least a part of the upper surface of the base 410 may be disposed facing directly with at least a part of the second substrate 241. Preferably, at least a part of the upper surface of the base 410 may be disposed facing directly with the lower surface of the second sub-region 241-22 of the second region of the second substrate 241.

The base 410 may include a through hole 411. The base 410 may have a mounting portion 412 formed around the through hole 411.

In addition, an adhesive member 430 may be disposed on the upper surface of the base 410. The adhesive member 430 may be able to couple the lens driving device 200 on the base 410. Preferably, the adhesive member 430 may be able to couple the holder 243 of the lens driving device 200 on the base 410.

In addition, an adhesive may be applied to the mounting portion 412 of the base 410. Through this, the infrared filter 420 may be disposed on the mounting portion 412 of the base 410. The mounting portion 412 may be a recess, cavity, or hole shape that is recessed from the upper surface of the base 410, but is not limited thereto. For example, the mounting portion 412 may be a protrusion protruding from the upper surface of the base 410. For example, the mounting portion 412 of the base 410 may mean a step portion that is provided corresponding to a region where the infrared filter 420 is disposed on the upper surface of the base 410.

The mounting portion 412 of the base 410 may serve to prevent a lower end of the lens module 100 from contacting or colliding with the infrared filter 420.

At this time, the mounting portion 412 may be formed along a side surface of the infrared filter 420. For example, the mounting portion 412 may be formed to surround the side surface of the infrared filter 420.

A shape of the mounting portion 412 as viewed from an upper side may be identical to a shape of the infrared filter 420, but is not limited thereto. A shape of the mounting portion 412 of another embodiment may be similar to or different from a shape of the infrared filter 420.

The through hole 411 of the base 410 allows light passing through the infrared filter 420 to be incident on the image sensor 320. The through hole 411 may pass through a center of the base 410. An area of the through hole 411 may be smaller than an area of the infrared filter 420.

The base 410 is disposed on the first substrate 310 of the driving substrate part 300. In addition, the base 410 may accommodate the infrared filter 420 therein. In addition, the base 410 may support the lens driving device 200 located on an upper side of the base.

In addition, the base 410 can support a connection pin 500 that electrically connects between the first substrate 310 and the second substrate 241. That is, the base 410 can fix the connection pin 500.

To this end, the base 410 can include an insertion hole 415. The insertion hole 415 can be a through hole penetrating the base 410. The insertion hole 415 can be aligned with the first terminal part 330 of the first substrate 310 and the second terminal part of the second substrate 241 along an optical axis in the base 410.

The insertion hole 415 may include a first insertion hole 415-1 corresponding to the first-first terminal part 331 of the first terminal part 330 and the second-first terminal part 241-2P of the second terminal part.

In addition, the insertion hole 415 may include a second insertion hole 415-2 corresponding to the first-second terminal part 332 of the first terminal part 330 and the second-second terminal part 241-3P of the second terminal part.

The first insertion hole 415-1 and the second insertion hole 415-2 may be spaced apart from an outer end of the base 410. For example, the first insertion hole 415-1 and the second insertion hole 415-2 may penetrate the base 410 at a position spaced apart from the outer end of the base 410.

Meanwhile, the first insertion hole 415-1 may have a number corresponding to the number of the first-first terminal part 331 and the second-first terminal part 241-2P. In addition, the second insertion hole 415-2 may have a number corresponding to the number of the first-second terminal part 332 and the second-second terminal part 241-3P.

A connection pin 500 may be inserted and disposed in the insertion hole 415 of the base 410. The connection pin 500 may be coupled to the base 410. The connection pin 500 can be fixed in a state of being inserted in the insertion hole 415 of the base 410.

The connection pin 500 can include a plurality of first connection pins 510 inserted in the first insertion hole 415-1. In addition, the connection pin 500 can include a plurality of second connection pins 520 inserted in the second insertion hole 415-2.

The connection pin 500 can be disposed on the base 410 to electrically connect the first terminal part 330 of the first substrate 310 and the second terminal part of the second substrate 241.

The first connection pin 510 can electrically connect between the first-first terminal part 331 and the second-first terminal part 241-2P. For example, one end of the first connection pin 510 can be in direct contact with the first-first terminal part 331, and the other end can be in direct contact with the second-first terminal part 241-2P. The first connection pin 510 can have a number corresponding to the number of terminals of each of the first-first terminal part 331 and the second-first terminal part 241-2P.

The second connection pin 520 can electrically connect between the first-second terminal part 332 and the second-second terminal part 241-3P. For example, one end of the second connection pin 520 may be in direct contact with the first-second terminal part 332, and the other end may be in direct contact with the second-second terminal part 241-3P. The second connection pin 520 may have a number corresponding to the number of terminals of each of the first-second terminal part 332 and the second-second terminal part 241-3P.

To this end, the connection pin 500 including the first connection pin 510 and the second connection pin 520 may include a body 501. The body 501 of the connection pin 500 may penetrate the base 410. For example, the body 501 of the connection pin 500 may be inserted and fixed in the insertion hole 415 of the base 410.

In addition, the connection pin 500 may include a connection part disposed in the body 501. For example, the connection pin 500 may include a connection part protruding from the body 501.

For example, the connection pin 500 may include a first connection part 502 protruding downward from the body 501. The first connection part 502 may be disposed to protrude in a lower direction of the base 410 while the body 501 is inserted in the insertion hole 415 of the base 410. The first connection part 502 may be electrically connected to the first terminal part 330 of the first substrate 310.

For example, the connection pin 500 may include a second connection part 503 protruding upward from the body 501. The second connection part 503 may protrude in an upper direction of the base 410 while the body 501 is inserted in the insertion hole 415 of the base 410. The second connection part 503 may be electrically connected to the second terminal part of the second substrate 241.

At this time, the connection pin 500 may have different structures depending on the embodiment. That is, the connection pin 500 may include a first connection part 502 and a second connection part 503. At this time, in one embodiment, the first connection part 502 and the second connection part 503 may have elasticity. In addition, in another embodiment, the first connection part 502 may not have elasticity, and the second connection part 503 may have elasticity. In addition, in another embodiment, both the first connection part 502 and the second connection part 503 may not have elasticity. This will be specifically described as follows.

That is, referring to FIG. 10a, the connection pin 500 of the first embodiment may include an elastic means (not shown). The elastic means may be disposed within the body 501 of the connection pin 500. Accordingly, the first connection part 502 and the second connection part 503 may be pressed into the body 501 by the elastic means. Accordingly, the first connection part 502 and the second connection part 503 may be firmly coupled to the first terminal part 330 and the second terminal part.

For example, as shown in (a) of FIG. 10a, the first connection part 502 and the second connection part 503 may protrude from the body 501 of the connection pin 500 with a first height, respectively, while not in contact with the first terminal part 330 and the second terminal part. In addition, as shown in (b) of FIG. 10a, the first connection part 502 and the second connection part 503 may be pressed by the elastic means while in contact with the first terminal part 330 and the second terminal part, thereby having a second height lower than the first height. Through this, the embodiment can firmly connect the first connection part 502 and the second connection part 503 to the first terminal part 330 of the first substrate 310 and the second terminal part of the second substrate 241, respectively, by the pressing by the elastic means.

Meanwhile, referring to FIG. 10b, the connection pin 500 of the second embodiment may be provided with an elastic means only in one of the plurality of connection parts. Preferably, the first connection part 502 of the connection pin 500 may not be provided with an elastic means. In addition, the second connection part 503 of the connection pin 500 may be provided with an elastic means.

Accordingly, referring to FIG. 10b (a) and (b), the first connection part 502 of the connection pin 500 may not have a height change in both a state of not contacting and a state of contacting the first terminal part 330 of the first substrate 310. For example, the body 501 and the first connection part 502 of the connection pin 500 of the second embodiment may be formed integrally. In addition, the second connection part 503 of the connection pin 500 may protrude with a first height in a state of not contacting the second terminal part of the second substrate 241, and may protrude with a second height lower than the first height in state of contacting the second terminal part. That is, when the first connection part 502 and the first terminal part 330 of the first substrate 310 are coupled, adjustment of a coupling position therebetween may not be necessary. Accordingly, the first connection part 502 may not be provided with an elastic means. However, when the second connection part 503 and the second terminal part of the second substrate 241 are coupled, adjustment of a coupling position therebetween may be necessary through an active align process. Accordingly, the second connection part 503 may be provided with an elastic means, and through this, an efficiency of the active align process may be improved. At this time, when the elastic means is not provided in the first connection part 502, in order to improve the bonding reliability between the first connection part 502 and the first terminal part 330 of the first substrate 310, a planar shape of the first connection part 502 may correspond to a planar shape of the first terminal part 330. Furthermore, the first terminal part 330 may be bent in the vertical direction and/or the horizontal direction. This will be described in more detail below.

Meanwhile, referring to FIG. 10c, the connection pin 500 of the third embodiment may not be provided with elastic means in all of the plurality of connection parts. Preferably, the first connection part 502 and the second connection part 503 of the connection pin 500 may not be provided with elastic means.

Accordingly, referring to FIG. 10c (a) and (b), the first connection part 502 of the connection pin 500 may not have a height change both in a state of not contacting and in a state of contacting with the first terminal part 330 of the first substrate 310. For example, the body 501 and the first connection part 502 of the connection pin 500 of the third embodiment may be formed integrally. In addition, the second connection part 503 may not have a height change both in a state of not contacting and in a state of being connected to the second terminal part of the second substrate 241. For example, the body 501 of the connection pin 500 and the second connection part 503 in the third embodiment may be formed integrally.

That is, when the first connection part 502 and the first terminal part 330 of the first substrate 310 are coupled, adjustment of the coupling position between them may not be necessary. Furthermore, in a case of a normal auto-focusing camera module that does not require an active alignment process, an elastic means may not be provided in the second connection part 503 connected to the second terminal part of the second substrate 241.

As described above, the first substrate 310 and the second substrate 241 of the embodiment are electrically connected using the connection pin 500 rather than a separate soldering process.

To this end, the first terminal part 330 of the first substrate 310 and the second terminal part of the second substrate 241 may be aligned with the optical axis. For example, the first terminal part 330 of the first substrate 310 and the second terminal part of the second substrate 241 can be aligned in the optical axis with the connection pin 500 interposed therebetween.

Meanwhile, a process for electrically connecting the first substrate 310 and the second substrate 241 using the connection pin 500 will be briefly described as follows.

First, the image sensor 320 can be attached to the first substrate 310. Thereafter, the base 410 equipped with the connection pin 500 can be disposed on the first terminal part 330 of the first substrate 310. At this time, an adhesive member such as epoxy can be applied while the first connection part 502 of the connection pin 500 is in contact with the first terminal part 330 of the first substrate 310. Through this, the first substrate 310 and the base 410 can be coupled.

Thereafter, the second substrate 241 can be disposed on the base 410. Thereafter, an adhesive member such as epoxy can be applied while the second connection part 503 of the connection pin 500 is connected to the second terminal part of the second substrate 241. At this time, an active align process can be performed according to the embodiment before applying the adhesive member. Then, the second substrate 241 of the lens driving device 200 can be coupled on the base 410 using the applied adhesive member.

Accordingly, the embodiment can omit a soldering process for electrically connecting the first terminal part and the second terminal part. As a result, the embodiment can solve electrical reliability and physical reliability problems occurring in the soldering process. In addition, the embodiment can solve the problem that cracks occur at the point where the soldering process is performed due to various factors.

Meanwhile, the base 410 of the filter part 400 may have different shapes or structures depending on the embodiment.

For example, as shown in FIG. 9 and FIG. 11, the base 410 of the first embodiment may include a region where the insertion hole 415 is formed and a peripheral region thereof. In addition, the region where the insertion hole 415 is formed in the base 410 and the peripheral region may be located on a same plane. For example, the region where the insertion hole 415 is formed in the base 410 and the peripheral region may not have a step. Through this, the embodiment can further improve a rigidity of the base 410. Therefore, the embodiment can minimize distortion of the base 410 in an usage environment of the camera module. In addition, the embodiment can minimize deformation of the base 410 due to physical impact and/or thermal stress applied to the base 410 in an usage environment of the camera module.

Meanwhile, referring to FIG. 13a, the base 410 may include a recess 413. For example, the base 410 may be provided with a recess 413 in a region surrounding the insertion hole 415 formed therein. The recess 413 may also be referred to as a concave portion that is concave from an upper surface of the base 410 toward a lower surface of the base 410. In addition, the recess 413 may be provided to surround a region where the insertion hole 415 is formed.

Specifically, the insertion hole 415 may include a first insertion hole 415-1 and a second insertion hole 415-2. In addition, the recess 413 may have a first part 413-1 provided around the first insertion hole 415-1. In addition, the recess 413 may include a second part 413-2 provided around the second insertion hole 415-2 while not being connected to the first part 413-1.

At this time, in FIG. 13a, the recess 413 is illustrated as being provided only on the upper surface of the base 410, but is not limited thereto. Preferably, the recess 413 may include a first recess provided on a lower surface of the base 410 and a second recess provided on an upper surface of the base 410. Through this, an epoxy application process can be improved through the first recess when bonding with the first substrate 310. Furthermore, the epoxy application process can be improved by utilizing the second recess when bonding with the second substrate 241.

At this time, the recess 413 provided in the base 410 of the second embodiment may be connected to an outer surface of the base 410. For example, the recess 413 may be exposed to a side portion of the base 410. Accordingly, in the second embodiment, when the base 410 is disposed on the first substrate 310, an epoxy side sealing process of applying an adhesive member, such as epoxy, to the recess 413 exposed through the side of the base 410 may be possible. For example, when the first connection part 502 of the connection pin 500 penetrating the base 410 is disposed on the first substrate 310, side sealing may be performed on a side portion of the base 410 to fill the first recess with epoxy. In addition, the second recess may be filled with epoxy while the second substrate 241 may be disposed on the second connection part 503 of the connection pin 500 penetrating the base 410. Through this, the embodiment may fill the recess 413 with an adhesive member such as epoxy. At this time, the recess 413 may function as a dam to prevent the epoxy from overflowing into a region other than the region where the insertion hole 415 is disposed (e.g., a region where the through hole 411 is provided) while allowing the epoxy to be applied through a side sealing process.

Meanwhile, referring to FIG. 13b, the recess 413 provided in the base 410 may not be connected to an outer surface of the base 410 in a manner different from the base of the second embodiment. For example, the recess 413 may be provided spaced apart from the outer surface of the base 410. In addition, the recess 413 can function as a dam to block the epoxy from overflowing in all directions.

Meanwhile, in a structure of the recess of FIG. 13b, the recess 413 can be implemented in a structure in which only a part of the recess is connected to the outer surface of the base 410 and the recess is not connected to an outer surface as a whole. In this case, the overflow of the epoxy filled in the recess can be minimized while a gas generated during the curing of the epoxy can be easily discharged to the outside.

Meanwhile, the base 410 can be composed of a plurality of layers. In addition, the recess 413 can be formed by processing any one of the plurality of layers. However, the embodiment is not limited thereto. The base 410 can be composed of a single layer, and the base 410 composed of the single layer can be processed to form a recess 413 that does not penetrate the base.

Meanwhile, the connection pin 500, the first terminal part 330 of the first substrate 310, and the second terminal part 241P of the second substrate 241 may have various structures.

For example, referring to FIG. 14a, the first connection part 502 of the connection pin 500 of the first embodiment and the first terminal part 330 of the first substrate 310 include a contact portion that contacts each other, and the contact portion may be flat.

In addition, a surface (e.g., a lower surface) of the first connection part 502 of the connection pin 500 that contacts the first terminal part 330 may be flat. In addition, a surface (e.g., an upper surface) of the first terminal part 330 that contacts the first connection part 502 may also be flat to correspond to the first connection part 502.

Meanwhile, the second connection part 503 of the connection pin 500 and the second terminal part 241P of the second substrate 241 may include a contact portion that contacts each other.

In addition, a surface (e.g., an upper surface) of the second connection part 503 of the connection pin 500 that contacts the second terminal part 241P may be flat. In addition, a surface (e.g., a lower surface) of the second terminal part 241P that contacts the second connection part 503 may also be flat to correspond to the second connection part 503.

Meanwhile, referring to FIG. 14b, the first connection part 502 of the connection pin 500 of the second embodiment and the first terminal part 330 of the first substrate 310 may include a contact portion that contacts each other, and the contact portion may be concave or convex.

In addition, a surface (e.g., a lower surface) of the first connection part 502 of the connection pin 500 that contacts the first terminal part 330 may include a convex portion that is convex toward the first terminal part 330. In addition, a surface (e.g., a upper surface) of the first terminal part 330 that contacts the first connection part 502 may include a concave portion that is concave toward the inside of the first terminal part 330 while corresponding to the convex portion of the first connection part 502. In addition, when the first substrate 310 and the base 410 are coupled, the convex portion of the first connection part 502 may be inserted in the concave portion of the first terminal part 330. Through this, the embodiment can prevent the misalignment between the first terminal part 330 and the first connection part 502 in a process of coupling the first connection part 502 and the first terminal part 330. Through this, the embodiment can improve the coupling reliability of the first terminal part 330 and the first connection part 502.

Meanwhile, the second connection part 503 of the connection pin 500 and the second terminal part 241P of the second substrate 241 may include a contact portion that contacts each other.

In addition, a surface (e.g., an upper surface) of the second connection part 503 of the connection pin 500 that contacts the second terminal part 241P may include a convex portion that is convex toward the second terminal part 241 P. In addition, a surface (e.g., a lower surface) of the second terminal part 241P that contacts the second connection part 503 may include a concave portion that is concave toward the inside of the second terminal part 241P while corresponding to the convex portion of the second connection part 503. In addition, when the second substrate 241 and the base 410 are coupled, the convex portion of the second connection part 503 may be inserted in the concave portion of the second terminal part 241P.

At this time, a width of the convex portion of the second connection part 503 may be different from a width of the concave portion of the second terminal part 241 P. Preferably, the width of the convex portion of the second connection part 503 may be smaller than the width of the concave portion of the second terminal part 241P. Through this, the embodiment can enable the positional movement of the second connection part 503 while the convex portion of the second connection part 503 is inserted in the concave portion of the second terminal part 241P. Through this, the embodiment can easily proceed with the active align process.

Meanwhile, referring to FIG. 14c, in the third embodiment, the first connection part 502 of the connection pin 500 and the first terminal part 330 of the first substrate 310 may include a contact portion that contacts each other, and the contact portion may be concave or convex.

In addition, a surface (e.g., a lower surface) of the first connection part 502 of the connection pin 500 that contacts the first terminal part 330 may include a concave portion that is concave toward the inside (e.g., toward the body 501). In addition, a surface (e.g., an upper surface) of the first terminal part 330 that contacts the first connection part 502 may include a convex portion that is convex toward the first connection part 502 while corresponding to the concave portion of the first connection part 502. In addition, when coupling the first substrate 310 and the base 410, the concave portion of the first connection part 502 can be inserted in the convex portion of the first terminal part 330. Through this, the embodiment can prevent the positional misalignment between the first terminal part 330 and the first connection part 502 in a process of coupling the first connection part 502 and the first terminal part 330. Through this, the embodiment can improve the coupling reliability of the first terminal part 330 and the first connection part 502.

Meanwhile, the second connection part 503 of the connection pin 500 and the second terminal part 241P of the second substrate 241 can include a contact portion that contacts each other.

In addition, a surface (e.g., upper surface) of the second connection part 503 of the connection pin 500 that contacts the second terminal part 241P may include a concave portion that is concave in an inward direction (e.g., toward the body 501). In addition, a surface (e.g., lower surface) of the second terminal part 241P that contacts the second connection part 503 may include a convex portion that is convex toward the second connection part 503 while corresponding to the concave portion of the second connection part 503. In addition, when the second substrate 241 and the base 410 are coupled, the concave portion of the second connection part 503 may be inserted in the convex portion of the second terminal part 241P.

At this time, a width of the concave portion of the second connection part 503 may be different from a width of the convex portion of the second terminal part 241 P. Preferably, the width of the concave portion of the second connection part 503 may be larger than the width of the convex portion of the second terminal part 241P. Through this, the embodiment can move a position of the second connection part 503 while the convex portion of the second terminal part 241P is inserted into the concave portion of the second connection part 503. Through this, the embodiment can easily perform the active align process.

Meanwhile, the connection pin 500, the first terminal part 330, and the second terminal part 241P of the embodiment can be implemented by a combination of the structures illustrated in FIGS. 14a to 14c.

For example, the first connection part 502 and the first terminal part 330 may have the structure illustrated in FIG. 14a, and the second connection part 503 and the second terminal part 241P may have the structure illustrated in FIG. 14b or FIG. 14c.

For example, the first connection part 502 and the first terminal part 330 may have the structure illustrated in FIG. 14b, and the second connection part 503 and the second terminal part 241P may have the structure illustrated in FIG. 14a or FIG. 14c.

For example, the first connection part 502 and the first terminal part 330 may have the structure illustrated in FIG. 14c, and the second connection part 503 and the second terminal part 241P may have the structure illustrated in FIG. 14a or FIG. 14b.

Meanwhile, the embodiment can secure a flatness of the base 410 compared to a comparative example, and through this, can secure the flatness of the infrared filter 420 mounted on the base 410.

That is, due to the recent technological development of the camera module, a size of the image sensor 320 is increasing, and accordingly, a size of the infrared filter 420 is also increasing.

At this time, as shown in FIG. 15, the base 410a of the camera module of the comparative example includes a first opening part 410b on which the infrared filter is disposed and a second opening part 410c and 410d through which the second substrate of the lens driving device passes. The base 410a of the comparative example had to have the second opening part 410c and 410d formed in a region corresponding to the second substrate for soldering between the first substrate and the second substrate. By this, a rigidity of the base 410a of the comparative example can be reduced by a region corresponding to the second opening part 410c and 410d. By this, the camera module of the comparative example has a problem in that the flatness of the base 410a is reduced, and thus the flatness of the infrared filter is reduced. Furthermore, the camera module of the comparative example had to secure a space for performing the soldering process of the first substrate and the second substrate.

In contrast, the base 410 of the embodiment can remove the second opening part 410c and 410d of the comparative example, and thus the rigidity of the base 410 can be improved. By this, the camera module of the embodiment can improve the flatness of the base 410 and further improve the flatness of the infrared filter 420.

In addition, the base of the comparative example is disposed such that the outer end of the first terminal part of the first substrate is positioned further outward than the outer end of the base by the second opening part 410c and 410d. In other words, the camera module of the comparative example does not have the first terminal part of the first substrate overlapped with the base in the optical direction. In addition, the first terminal part of the first substrate of the camera module of the comparative example overlaps with the second opening part 410c and 410d of the base along the optical axis.

In contrast, the outer end of the base 410 of the embodiment may be positioned further outward than the outer end of the first terminal part 330. This means that the insertion hole 415 of the base 410 is positioned at a position spaced from the outer end of the base 410, and the first terminal part 330 overlaps with the insertion hole 415 along the optical axis. By this, the outer end of the base 410 can be disposed further outward than the outer end of the first terminal part 330. In other words, at least a part of the first terminal part 330 can overlap the base 410 along the optical axis. In other words, a peripheral region of the first terminal part 330 of the first substrate 310 overlaps the base 410 along the optical axis.

Furthermore, as illustrated in (a) of FIG. 16, in the camera module of the comparative example, a soldering process of the first substrate 310a and the second substrate 241a is performed outside the cover member 210a. Accordingly, a soldering portion SB electrically connecting the first substrate 310a and the second substrate 241a is disposed outside the cover member 210a of the camera module. Therefore, the camera module of the comparative example may have electrical reliability and physical reliability problems due to the solder portion SB being exposed to the outside in the usage environment.

In contrast, as illustrated in (b) of FIG. 16, the camera module of the embodiment electrically connects the first substrate 310 and the second substrate 241 using the connection pin 500.

Accordingly, the embodiment may have a contact point at which the first terminal part 330 of the first substrate 310 and the second terminal part of the second substrate 241 are connected to each other located inside the camera module. Accordingly, the embodiment may protect the contact point from various factors. Accordingly, the embodiment may improve the electrical connectivity between the first substrate 310 and the second substrate 241. Furthermore, the embodiment may improve the operational reliability of the camera module.

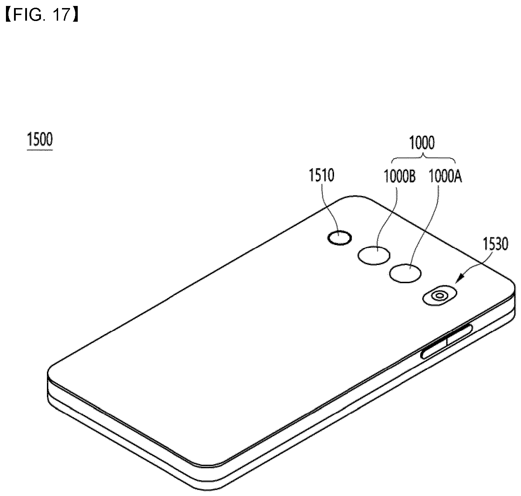

FIG. 17 shows a mobile terminal to which a camera module according to an embodiment is applied.

As shown in FIG. 17, the mobile terminal 1500 according to the embodiment may include a camera module 1000, a flash module 1530, and an autofocus device 1510 provided on a back surface. The mobile terminal 1500 of the embodiment may further include a second camera module 1100.

The camera module 1000 may include an image capturing function and an autofocus function. For example, the camera module 1000 may include an autofocus function using an image. The camera module 1000 may be the camera module illustrated in FIG. 1.

The camera module 1000 processes a still image or a moving image frame obtained by an image sensor in a photographing mode or a video call mode. The processed image frame may be displayed on a predetermined display unit, and may be stored in a memory. A camera (not shown) may be disposed on a front surface of the body of the mobile terminal.

For example, the camera module 1000 may include a first camera module and a second camera module, and OIS may be implemented together with an AF or zoom function by the first camera module.

The flash module 1530 may include a light-emitting device that emits light therein. The flash module 1530 may be operated by a camera operation of a mobile terminal or by user control.

The autofocus device 1510 may include one of packages of a surface emitting laser element as a light-emitting unit.

The autofocus device 1510 may include an autofocus function using a laser. The autofocus device 1510 may be mainly used in a condition in which an autofocus function using an image of the camera module 1000 is deteriorated, for example, in a close environment of 10 m or less or a dark environment. The autofocus device 1510 may include a light-emitting unit including a vertical cavity surface emitting laser (VCSEL) semiconductor device, and a light receiving unit that converts light energy into electric energy such as a photodiode.

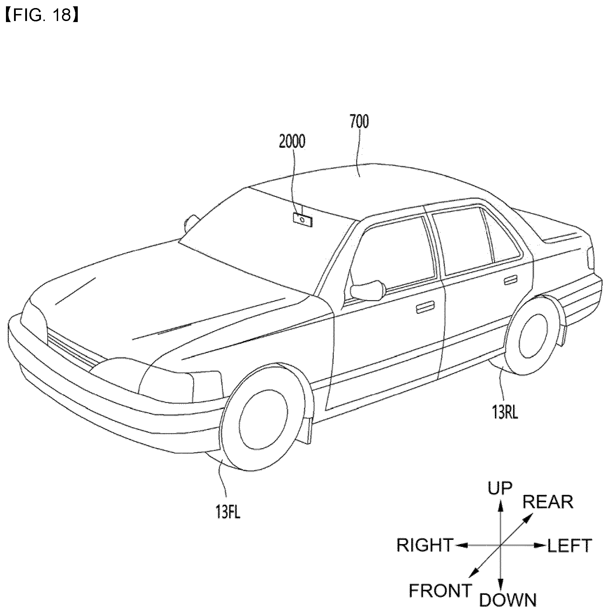

FIG. 18 is a perspective view of a vehicle 700 to which a camera module according to an embodiment is applied,

For example, FIG. 18 is an appearance view of a vehicle having a vehicle driving assistance device to which a camera module 1000 according to the embodiment is applied.

Referring to FIG. 18, the vehicle 700 according to the embodiment may include wheels 13FL and 13FR that rotate by a power source, and a predetermined sensor. The sensor may be a camera sensor 2000, but the embodiment is not limited thereto.

The camera 2000 may be a camera sensor to which the camera module 1000 according to the embodiment is applied.

The vehicle 700 according to the embodiment may acquire image information through the camera sensor 2000 that photographs a front image or a surrounding image, and may determine an unidentified situation of a lane by using the image information and generate a virtual lane at the time of un-identification.

For example, the camera sensor 2000 may acquire the front image by photographing a front of the vehicle 700, and a processor (not shown) may acquire the image information by analyzing an object included in the front image.

For example, when an object such as a lane, a neighboring vehicle, a traveling obstacle, and a median strip, a curb, and a street tree corresponding to an indirect road marking is photographed in an image photographed by the camera sensor 2000, the processor detects such an object to include in the image information.

In this case, the processor may acquire distance information with the object detected through the camera sensor 2000 to further complement the image information. The image information may be information about an object captured in the image.

Such a camera sensor 2000 may include an image sensor and an image processing module. The camera sensor 2000 may process a still image or moving image obtained by the image sensor (e.g., CMOS or CCD. The image processing module may process the still image or moving image acquired through the image sensor to extract necessary information, and may transmit the extracted information to the processor.

At this time, the camera sensor 2000 may include a stereo camera so as to improve the measurement accuracy of the object and to secure more information such as a distance between the vehicle 700 and the object, but the embodiment is not limited thereto.

The vehicle 700 of the embodiment may provide an advanced driver assistance system (ADAS).

For example, the advanced driver assistance system (ADAS) may include an autonomous emergency braking system (AEB) that automatically reduces or stops the vehicle without the driver stepping on a brake pedal when there is a risk of collision, a lane keep assist system (LKAS) that adjusts a driving direction when the vehicle departs from the lane to maintain the lane, an advanced smart cruise control (ASCC) that automatically maintains a distance from a vehicle in front while driving at a preset speed, an active blind spot detection (ABSD) that detects the risk of collision in a blind spot and helps change the lane safely, an around view monitoring system (AVM) that visually displays the situation around the vehicle, etc.

In these advanced driver assistance systems (ADAS), the camera module functions as a core component along with radar, etc., and a proportion to which camera modules are applied is gradually expanding.

For example, in a case of the automatic emergency braking system (AEB), the vehicle's front camera sensor and radar sensor can detect a vehicle or pedestrian in front, and automatically apply emergency brakes when the driver is not controlling the vehicle. Alternatively, in the case of the lane keep assist system (LKAS), the camera sensor can detect whether the driver is leaving the lane without using a turn signal, and automatically steer a steering wheel to maintain the lane. In addition, the around view monitoring system (AVM) can visually display the situation around the vehicle through camera sensors disposed on all sides of the vehicle.

The characteristics, structures and effects described in the embodiments above are included in at least one embodiment but are not limited to one embodiment. Furthermore, the characteristics, structures, effects, and the like illustrated in each of the embodiments may be combined or modified even with respect to other embodiments by those of ordinary skill in the art to which the embodiments pertain. Thus, it would be construed that contents related to such a combination and such a modification are included in the scope of the present invention.

In addition, embodiments are mostly described above, but they are only examples and do not limit the present invention. A person skilled in the art to which the present invention pertain may appreciate that several variations and applications not presented above may be made without departing from the essential characteristic of the embodiments. For example, each component particularly represented in the embodiments may be varied. In addition, it should be construed that differences related to such a variation and such an application are included in the scope of the present invention defined in the following claims.

## Claims

1. A camera module comprising:
a first substrate having a first terminal part;
an image sensor disposed on the first substrate;
a base disposed on the first substrate;
a lens driving device including a second substrate disposed on the base and having a second terminal part; and
a connection pin penetrating the base, and
wherein one end of the connection pin contacts the first terminal part, and the other end of the connection pin contacts the second terminal part.

2. The camera module of claim 1, wherein the connection pin includes:
a body penetrating the base,
a first connection part having the one end protruding in a lower direction of the body and contacting the first terminal part; and
a second connection part having the other end protruding in an upper direction of the body and contacting the second terminal part.

3. The camera module of claim 2, wherein at least one of the first connection part and the second connection part has elasticity.

4. The camera module of claim 2, wherein the base includes an insertion hole into which the body of the connection pin is inserted, and
wherein the insertion hole penetrates the base at a position spaced from an outer end of the base.

5. The camera module of claim 4, wherein the base includes
a first region including the insertion hole, and
a second region adjacent to the first region, and
wherein the first region and the second region do not have a step.

6. The camera module of claim 4, wherein the base includes
a first region including the insertion hole, and
a second region adjacent to the first region, and
wherein the first region and the second region have a step.

7. The camera module of claim 6, wherein the first region of the base is provided with a recess corresponding to the step, and
wherein the recess includes:
a first recess provided on one surface of the base, in which a first adhesive member for coupling the first connection part and the first terminal part is disposed, and
a second recess provided on the other surface of the base opposite to the one surface, in which a second adhesive member for coupling the second connection part and the second terminal part is disposed.

8. The camera module of claim 3, wherein the lens driving device includes a driving coil disposed on the second substrate,
wherein the second terminal part includes a plurality of second terminals, and
wherein at least one of the plurality of second terminals is electrically connected to the driving coil.

9. The camera module of claim 8, wherein the lens driving device further includes a mover that moves with respect to the second substrate and includes a sensor unit, and
wherein at least another one of the plurality of second terminals includes a terminal electrically connected to the sensor unit.

10. The camera module of claim 8, wherein the first terminal part and the second terminal part overlap in an optical axis direction,
wherein the insertion hole is aligned with the first terminal part and the second terminal part in the optical axis direction, and
wherein a peripheral region adjacent to the first terminal part among an upper surface of the first substrate overlaps with the base in the optical axis direction.
